(19) Europäisches Patentamt
European Patent Office
Office européen des brevets

(11) **EP 3 224 634 B1**

(12) **FASCICULE DE BREVET EUROPEEN**

(45) Date de publication et mention
de la délivrance du brevet:
**01.05.2019 Bulletin 2019/18**

(21) Numéro de dépôt: **15808755.1**

(22) Date de dépôt: **26.11.2015**

(51) Int Cl.:
***G01R 31/36*** (2019.01)

(86) Numéro de dépôt international:
**PCT/FR2015/053239**

(87) Numéro de publication internationale:
**WO 2016/083753 (02.06.2016 Gazette 2016/22)**

(54) **PROCEDE AUTOMATIQUE D'ESTIMATION DE L'ETAT DE CHARGE D'UNE CELLULE D'UNE BATTERIE**

**AUTOMATISCHES VERFAHREN ZUR ABSCHÄTZUNG DES LADEZUSTANDS EINER BATTERIEZELLE**

**AUTOMATIC METHOD OF ESTIMATING THE CHARGE STATE OF A BATTERY CELL**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2014 FR 1461615**

(43) Date de publication de la demande:
**04.10.2017 Bulletin 2017/40**

(73) Titulaire: **Renault S.A.S.**
**92100 Boulogne-Billancourt (FR)**

(72) Inventeurs:
• **HEIRIES, Vincent**
**38430 Saint-Jean-de-Moirans (FR)**
• **LEIRENS, Sylvain**
**38000 Grenoble (FR)**

(74) Mandataire: **Colombo, Michel**
**Innovation Competence Group**
**310, avenue Berthelot**
**69372 Lyon Cedex 08 (FR)**

(56) Documents cités:
**US-A1- 2005 046 388    US-B1- 6 441 586**

**Description**

L'invention concerne un procédé automatique d'estimation de l'état de charge d'une cellule d'une batterie ainsi qu'un support d'enregistrement et un système de gestion de batterie pour mettre en oeuvre ce procédé. L'invention a également pour objet un véhicule automobile comportant ce système de gestion de batterie.

Des procédés connus d'estimation de l'état de charge d'une cellule d'une batterie comportent la réitération des étapes suivantes à chaque instant k successif :

a) l'acquisition d'une valeur mesurée $y_k$ d'une tension entre des bornes de la cellule et d'une intensité mesurée $i_k$ d'un courant de charge et de décharge de cette cellule,

b) le calcul d'une prédiction de l'état de charge SOCk, à l'instant k, de la cellule à l'aide d'un modèle d'état reliant la prédiction SOCk à un produit $F_k*SOC_{k-1}$ et à la valeur $y_{k-1}$ ou à l'intensité $i_{k-1}$ mesurée à l'instant k-1, où $SOC_{k-1}$ est l'état de charge de cette cellule à l'instant k-1 et $F_k$ est une matrice de transition d'état, cette prédiction $SOC_k$ étant entachée d'un bruit d'état dont la covariance est donnée par une matrice $Q_k$ de covariance du bruit d'état,

c) la prédiction de la covariance de l'erreur commise sur la prédiction de l'état de charge en fonction, notamment, de la matrice $Q_{k-1}$ de covariance du bruit d'état à l'instant k-1 et d'une matrice $R_{k-1}$ de covariance du bruit de mesure à l'instant k-1,

d) le calcul d'une prédiction $\hat{y}_k$ de la valeur mesurée $y_k$ à l'instant k à l'aide d'un modèle d'observation qui relie la valeur mesurée $y_k$ à un produit $H_k*SOC_k$, où $H_k$ est une matrice d'observabilité, cette prédiction $\hat{y}_k$ étant entachée d'un bruit de mesure dont la covariance est donnée par la matrice $R_k$ de covariance du bruit de mesure, et

e) la correction de la prédiction de l'état de charge $SOC_k$ en fonction de l'écart entre la valeur mesurée $y_k$ et sa prédiction $\hat{y}_k$.

Un tel procédé est en particulier décrit dans la partie 3 de l'article suivant : L. Plett, et al. : «Extended Kalman filtering for battery management systems of LiPB-based HEV battery packs », journal of Power Sources, 2004, page 252-292. Par la suite, cet article est désigné par l'abréviation « Plett 2004 ».

De l'état de la technique est également connu de : US2005/0046388A1 et US6441586B1.

En pratique, il est difficile de régler les matrices $Q_k$ et $R_k$ de ces procédés d'estimation. Ceci est particulièrement vrai pour la matrice $Q_k$ car il est difficile de quantifier a priori l'erreur de modélisation commise.

L'invention vise à remédier à cet inconvénient en proposant un procédé automatique d'estimation de l'état de charge d'une cellule dans lequel le réglage des matrices $Q_k$ et $R_k$ est simplifié. Elle a donc pour objet un procédé d'estimation de l'état de charge d'une cellule d'une batterie conforme à la revendication 1.

Dans le procédé ci-dessus, les matrices $Q_k$ et $R_k$ sont réglées à partir des matrices connues $F_k$ et $H_k$ des modèles d'état et d'observation, et d'un nombre entier $N_0$. Dans le procédé ci-dessus, l'utilisateur n'a qu'à choisir une valeur pour l'entier $N_0$ au lieu d'avoir à fixer, comme dans les procédés connus, chacun des coefficients des matrices $Q_k$ et $R_k$. Dans le procédé ci-dessus, le réglage des matrices $Q_k$ et $R_k$ est donc bien plus simple.

Les modes de réalisation de ce procédé automatique d'estimation peuvent comporter une ou plusieurs des caractéristiques des revendications dépendantes

Ces modes de réalisation du procédé d'estimation présentent en outre les avantages suivants :

- Réitérer le réglage des matrices $Q_k$ et $R_k$ à chaque fois que l'une des matrices $F_k$ et $H_k$ est modifiée permet d'augmenter la précision de l'état de charge estimé.

L'invention a également pour objet un support d'enregistrement d'informations comportant des instructions pour l'exécution du procédé automatique d'estimation ci-dessus lorsque ces instructions sont exécutées par un calculateur électronique.

L'invention a également pour objet un système de gestion d'une batterie conforme à la revendication 7.

Enfin, l'invention a également pour objet un véhicule automobile conforme à la revendication 8.

L'invention sera mieux comprise à la lecture de la description qui va suivre, donnée uniquement à titre d'exemple non limitatif et faite en se référant aux dessins sur lesquels :

- la figure 1 est une illustration schématique partielle d'un véhicule automobile équipé d'une batterie électrique,
- la figure 2 est une illustration schématique d'un modèle électrique d'une cellule de la batterie du véhicule de la figure 1 ;
- la figure 3 est une illustration schématique d'un agencement d'estimateurs utilisé pour estimer l'état de charge d'une cellule de la batterie du véhicule de la figure 1,
- les figures 4 à 9 représentent des équations de différents modèles d'état et d'observation utilisés par les estimateurs de la figure 3 ;
- la figure 10 est un organigramme d'un procédé d'estimation de l'état de charge d'une cellule à l'aide des estimateurs de la figure 3 ;

- la figure 11 est un organigramme d'un procédé de détermination de l'état de charge de la batterie du véhicule de la figure 1 ;
- la figure 12 est un organigramme d'un procédé de planification des instants de rafraîchissement des estimations des états de charge de différentes cellules d'une batterie ;
- la figure 13 est un chronogramme illustrant différents instants de rafraîchissement planifiés à l'aide du procédé de la figure 12;
- la figure 14 est une illustration schématique d'un autre agencement d'estimateurs utilisé pour estimer l'état de charge d'une cellule de la batterie du véhicule de la figure 1;
- les figures 15 et 16 représentent, respectivement, un modèle d'état et un modèle d'observation utilisé par les estimateurs de la figure 14 ;
- la figure 17 est un organigramme d'un procédé d'estimation de l'état de charge d'une cellule à l'aide des estimateurs de la figure 14 ;
- la figure 18 est une illustration d'un autre modèle d'état possible pour prédire la capacité et la résistance interne d'une cellule d'une batterie.

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description par « puissance de calcul », on désigne le nombre d'opérations à exécuter par un calculateur électronique. Ainsi, diminuer la puissance de calcul signifie diminuer le nombre d'opérations à réaliser pour atteindre le même résultat ou un résultat de même nature.

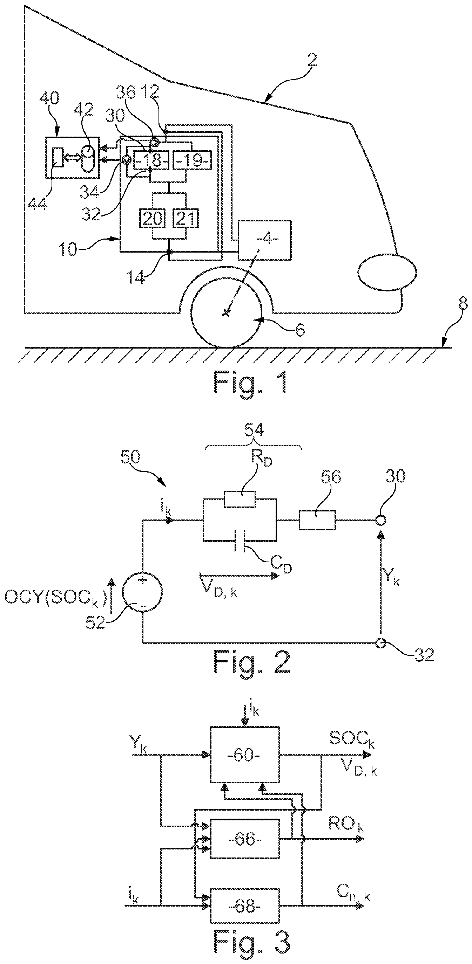

La figure 1 représente un véhicule automobile 2 à tractions électriques plus connu sous le terme de « véhicule électrique ». Les véhicules électriques sont bien connus et seuls les éléments structurels nécessaires pour comprendre la suite de cette description sont présentés. Le véhicule 2 comporte :

- un moteur électrique 4, apte à entraîner en rotation des roues motrices 6 pour faire rouler le véhicule 2 sur une chaussée 8, et
- une batterie 10 qui alimente en énergie électrique le moteur 4.

La batterie 10 comporte deux bornes 12, 14 de raccordement électrique et plusieurs cellules électriques raccordées électriquement entre ces bornes 12 et 14. Les bornes 12 et 14 sont raccordées aux charges électriques à alimenter. Ici, elles sont donc notamment raccordées au moteur électrique 4.

Pour simplifier la figure 1, seules quatre cellules électriques 18 à 21 sont représentées. Typiquement, ces cellules électriques sont regroupées en plusieurs étages et ces étages sont raccordés en série entre les bornes 12 et 14. Ici, seuls deux étages sont représentés. Le premier étage comporte les cellules 18 et 19, et le second étage comporte les cellules 20 et 21. Chaque étage comporte plusieurs branches raccordées en parallèle. Chaque branche d'un étage comporte une cellule électrique ou plusieurs cellules électriques en série. Ici, le premier étage comporte deux branches, et chaque branche comporte une seule cellule électrique. Le deuxième étage est structurellement identique au premier étage dans l'exemple représenté sur la figure 1.

Ici, toutes les cellules de la batterie 10 sont structurellement identiques aux tolérances de fabrication près. Par conséquent, seule la cellule 18 est maintenant décrite plus en détail.

La cellule 18 comporte deux bornes de raccordement électrique 30, 32 qui la raccorde électriquement aux autres cellules et aux bornes 12 et 14 de la batterie 10. La cellule 18 est aussi fixée mécaniquement, sans aucun degré de liberté aux autres cellules de la batterie 10 pour former ce que l'on appelle fréquemment un « pack » de cellules. La cellule 18 est capable de stocker de l'énergie électrique lorsqu'elle n'est pas utilisée. Cette énergie électrique stockée est ensuite utilisée pour alimenter le moteur 4, ce qui décharge la cellule 18. En alternance, la cellule 18 peut aussi recevoir de l'énergie électrique ce qui la charge. La décharge complète d'une cellule suivie de sa recharge complète constitue ce que l'on appelle un cycle de charge/décharge appelé simplement par la suite « cycle d'une cellule ».

La cellule 18 est une cellule de type connu, par exemple, il s'agit d'une cellule LiPB (Lithium-ion Polymer Battery) ou autre.

La cellule 18 se caractérise par une capacité nominale initiale $C_n^{ini}$, une résistance interne initiale $RO^{ini}$, une intensité $I_{max}$ de courant débité, une tension maximale $U_{max}$, une tension minimale $U_{min}$ et une fonction $OCV(SOC_k)$. La capacité $C_n^{ini}$ est la capacité initiale de la cellule 18. La capacité d'une cellule représente la quantité maximale d'énergie électrique qui peut être stockée dans cette cellule. Cette capacité est exprimée en Ah. Au fur et à mesure que la cellule 18 vieillit, c'est-à-dire au fur et à mesure que le nombre de cycles de charge et de décharge augmente, la capacité de la cellule diminue. À l'instant k, la capacité nominale de la cellule 18 est notée $C_{n,k}$ par la suite.

La résistance interne initiale $RO^{ini}$ est la valeur de la résistance interne de la cellule 18 avant que celle-ci ne commence à vieillir. La résistance interne d'une cellule est une grandeur physique que l'on retrouve dans la plupart des modèles électriques d'une cellule électrique. Lorsque la cellule vieillit, typiquement, la résistance interne augmente. À l'instant k, la résistance interne de la cellule 18 est notée $RO_k$.

$I_{max}$ est l'intensité maximale du courant qui peut être délivrée par la cellule 18 sans l'endommager.

$U_{max}$ est la tension maximale qui peut être présente en permanence entre les bornes 30 et 32 de la cellule sans l'endommager.

La tension $U_{min}$ est la tension minimale entre les bornes 30 et 32 lorsque la cellule 18 est complètement déchargée. Par la suite, on considère que $I_{max}$, $U_{max}$, $U_{min}$ sont des grandeurs physiques constantes qui ne varient pas au cours du temps.

OCV(SOCk) est une fonction prédéterminée qui retourne la tension à vide de la cellule 18 en fonction de son état de charge $SOC_k$. La tension à vide est la tension mesurable entre les bornes 30 et 32 après que la cellule 18 ait été isolée électriquement de toute charge électrique pendant deux heures.

L'état de charge à l'instant k de la cellule 18 est noté $SOC_k$. L'état de charge représente le taux de remplissage de la cellule 18. Il est égal à 100 % lorsque la quantité d'énergie électrique stockée dans la cellule 18 est égale à sa capacité $C_{n,k}$. Il est égal à 0 % lorsque la quantité d'énergie stockée dans la cellule 18 est nulle, c'est-à-dire qu'il ne peut plus être extrait d'énergie électrique de la cellule 18 pour alimenter une charge électrique.

Les paramètres $C_n^{ini}$, $RO^{ini}$, $I_{max}$, $U_{max}$, $U_{min}$ et la fonction OCV($SOC_k$) sont des paramètres connus de la cellule. Par exemple, ils sont donnés par le constructeur de la cellule ou sont déterminés expérimentalement à partir de mesures réalisées sur cette cellule.

La batterie 10 comporte également pour chaque cellule :

- un voltmètre qui mesure la tension entre les bornes de cette cellule, et
- un ampèremètre qui mesure l'intensité du courant de charge ou de décharge de cette cellule.

Pour simplifier la figure 1, seuls un voltmètre 34 et un ampèremètre 36 de la cellule 18 ont été représentés.

Contrairement aux différents paramètres de la cellule 18 introduits précédemment, l'état de charge $SOC_k$ de la cellule 18 n'est pas mesurable. Il doit donc être estimé. À cet effet, le véhicule 2 comporte un système 40 de gestion de la batterie 10 plus connu sous l'acronyme BMS (« Battery Management System »). Ce système 40 a notamment pour fonction de déterminer l'état de charge de la batterie 10 ainsi que l'état de santé de cette batterie. Pour déterminer cet état de charge et cet état de santé, le système 40 est capable d'estimer l'état de charge et l'état de santé de chaque cellule de la batterie 10. L'état de santé d'une cellule représente l'état d'avancement du vieillissement de cette cellule. Ici, l'état de santé d'une cellule, à l'instant k, est noté $SOH_k$. Par la suite, il est mesuré par le rapport $C_{n,k}/C_n^{ini}$. Pour calculer l'état de santé d'une cellule, le système 40 est donc aussi capable d'estimer la capacité $C_{n,k}$ de cette cellule à l'instant courant k.

Pour réaliser ces différentes estimations, le système 40 est électriquement raccordé à chaque voltmètre et chaque ampèremètre de la batterie 10 pour acquérir les mesures de la tension et de l'intensité du courant entre les bornes de chaque cellule.

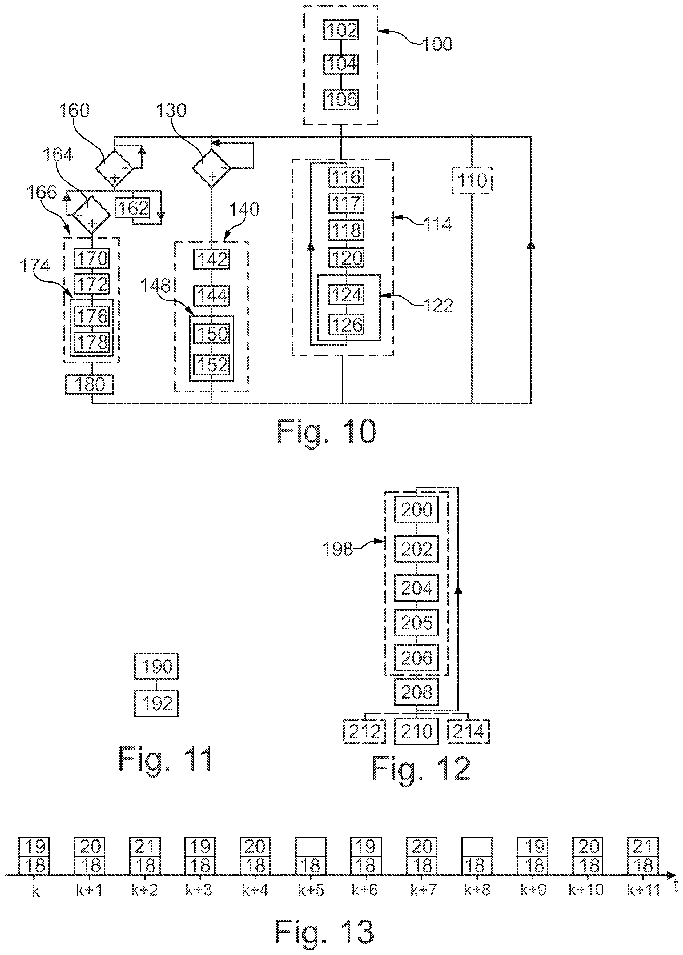

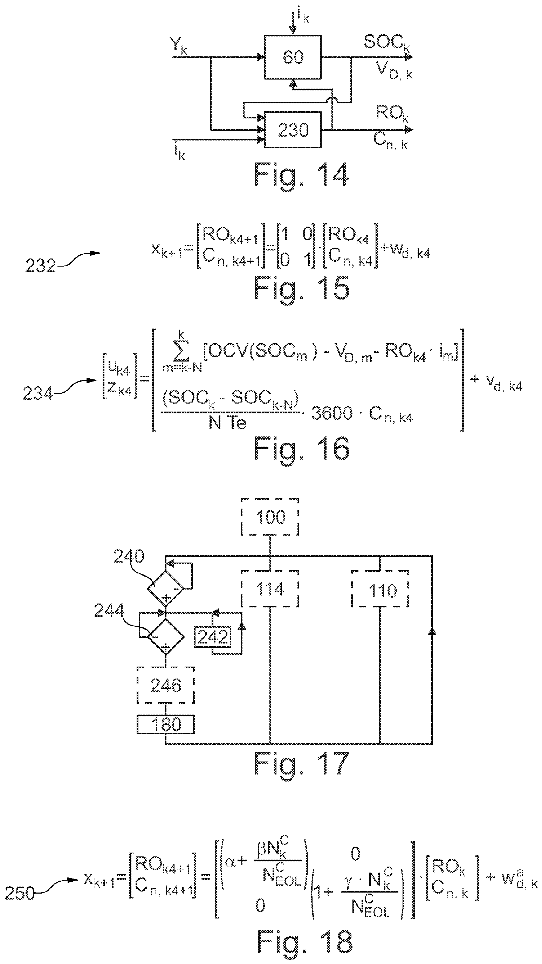

Ici, le système 40 comporte une mémoire 42 et un calculateur électronique 44 programmable, apte à exécuter des instructions enregistrées dans la mémoire 42. À cet effet, la mémoire 42 comporte les instructions nécessaires pour l'exécution des procédés des figures 10 à 12 et/ou de la figure 17. Cette mémoire 42 comporte aussi les valeurs initiales des différents paramètres nécessaires à l'exécution de ces procédés. La structure du système 40 est donc identiques ou similaire à celles des systèmes connus de gestion d'une batterie et n'est pas décrite plus en détail.

La figure 2 représente un modèle électrique 50 de la cellule 18. Ce modèle est connu sous le terme de « Modèle de Thévenin du premier ordre » ou « Lumped parameter model ». Il comporte successivement raccordé en série en partant de la borne 32 jusqu'à la borne 30 :

- un générateur 52 de la tension à vide OCV($SOC_k$),
- un circuit RC parallèle 54, et
- une résistance interne 56 appelée par la suite, à l'instant k, « résistance interne $RO_k$ ».

Le circuit 54 comporte un condensateur de capacité $C_D$ raccordé en parallèle avec une résistance de valeur $R_D$. Par la suite, on considère que ces deux paramètres $C_D$ et $R_D$ du modèle 50 sont connus et constants au cours du temps. La tension à l'instant k aux bornes du circuit 54 est notée $V_{D,k}$. La valeur à l'instant k de la tension entre les bornes 30 et 32 de la cellule 18 est notée $y_k$ et l'intensité, au même instant, du courant de charge ou de décharge de la cellule 18 est notée $i_k$.

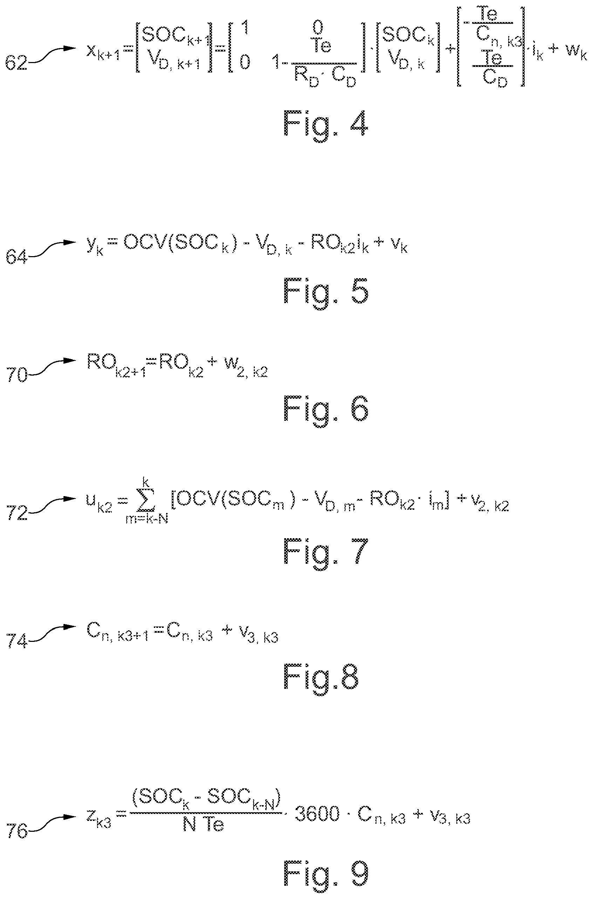

La figure 3 représente un premier mode de réalisation d'un agencement d'estimateurs implémenté dans le système 40 pour estimer l'état de charge et l'état de santé de la cellule 18. Chaque estimateur est implémenté sous la forme d'un algorithme d'estimation exécuté par le calculateur. Ainsi, on parlera pas la suite aussi bien « d'exécution d'un estimateur » que « d'exécution d'un algorithme d'estimation ». Dans ce premier mode de réalisation, le système 40 comporte un estimateur 60 de l'état de charge $SOC_k$ et de la tension $V_{D,k}$ à partir de la valeur mesurée $y_k$ de la tension et de l'intensité mesurée $i_k$. L'estimateur 60 est ici implémenté sous la forme d'un filtre de Kalman. Il utilise donc un modèle d'état 62 (figure 4) et un modèle d'observation 64 (figure 5). Dans ces figures 4 et 5, les équations de ces modèles sont représentées en utilisant les notations précédemment définies. Les notations $RO_{k2}$ et $C_{n,k3}$ représentent, respectivement, la capacité et la résistance interne de la cellule 18, respectivement, à des instants k2 et k3. Ces instants k2 et k3 sont définis par la suite. De plus, dans le modèle 62, $x_k$ désigne le vecteur d'état $[SOC_k, V_{D,k}]^T$ à l'instant k. Dans cette description, le symbole « $T$ » désigne l'opération transposée mathématique. L'opération multiplication est représentée par l'opérateur « . » ou « * ».

Par la suite, on considère que l'origine des temps correspond à la valeur nulle de l'instant k. Dans ces conditions, l'instant k courant est égal à $kT_e$, où $T_e$ est la période d'échantillonnage des mesures des ampèremètres et voltmètres de la batterie 10. Ainsi, $T_e$ est la période de temps qui sépare deux instants quelconques successifs k et k-1 d'acquisition de la tension et de l'intensité du courant par le système 40. La période $T_e$ est typiquement une constante comprise entre 0,1 s et 10 s. Ici, la période $T_e$ est égale à 1 s à plus ou moins 20 % près. Par exemple, $T_e$ est égale à une seconde.

Dans le modèle 62, $w_k$ est un vecteur de bruit d'état. Ici, le bruit $w_k$ est un bruit blanc gaussien centré. Ce bruit représente l'incertitude sur le modèle utilisé. La matrice de covariance, à l'instant k, du bruit $w_k$ est notée $Q_k$. Elle est définie par la relation suivante : $Q_k = E(w_k * w_k^T)$, où E(...) est la fonction espérance mathématique. Le modèle 62 s'écrit également sous la forme $X_{k+1} = F_k x_k + B_k i_k + w_k$, où :

- $F_k$ est la matrice de transition d'état à l'instant k,
- $B_k$ est le vecteur de commande à l'instant k.

Le modèle 62 permet notamment de prédire l'état de charge $SOC_{k+1}$ à l'instant k+1 à partir de l'état de charge précédant $SOC_k$.

Le modèle 64 permet de prédire la valeur $y_k$ de la tension à l'instant k à partir de l'état de charge $SOC_k$, de la tension $V_{D,k}$ et de l'intensité mesurée $i_k$. Dans ce modèle, $v_k$ est un bruit de mesure blanc gaussien centré. La matrice de covariance du bruit $v_k$ à l'instant k est notée $R_k$ par la suite. Dans le cas particulier décrit ici, cette matrice $R_k$ est une matrice à une seule colonne et à une seule ligne. Elle est définie par la relation $R_k = E(v_k * v_k^T)$. Ce bruit $v_k$ est indépendant du bruit $w_k$ et du vecteur d'état initial $x_0$.

On notera que le modèle 64 est non linéaire, car la fonction $OCV(SOC_k)$ est généralement non linéaire. À cause de cela, l'estimateur 60 implémente la version étendue du filtre de Kalman, plus connu sous l'acronyme EKF (Extended Kalman Filter). Dans cette version étendue, on se ramène à un modèle linéaire d'observation de la forme $y_k = H_k x_k + RO_{k2}.i_k + v_k$ en linéarisant le modèle 64 au voisinage du vecteur $x_k$. Typiquement, le modèle 64 est développé en série de Taylor au voisinage du vecteur $x_k$. Puis on néglige les contributions des dérivées à partir du second ordre. Ici, la matrice $H_k$ est donc égale à la dérivée première de la fonction OCV au voisinage de l'état de charge $SOC_k$. Cette linéarisation du modèle 64 est typiquement réalisée pour chaque nouvelle valeur de l'état de charge $SOC_k$.

L'estimateur 60 a besoin de connaître la capacité $C_{n,k3}$ et la résistance interne $RO_{k2}$ pour être capable d'estimer l'état de charge $SOC_{k+1}$. La capacité et la résistance interne de la cellule 18 varient au fur et à mesure qu'elle vieillit. Pour tenir compte de ce vieillissement, la capacité et la résistance interne de la cellule 18 sont estimées, respectivement, à des instants k3 et k2. Ici, un estimateur 66 estime la résistance interne $RO_{k2}$ à partir de la valeur mesurée $y_{k2}$, de l'intensité mesurée $i_{k2}$ et de l'état de charge $SOC_{k2}$. Un autre estimateur 68 estime la capacité $C_{n,k3}$ à partir de l'intensité $i_{k3}$ et de l'état de charge $SOC_{k3}$.

La résistance interne et la capacité de la cellule 18 varient plus lentement que son état de charge. Ainsi, pour limiter la puissance de calcul requise pour estimer l'état de charge de la cellule sans pour autant dégrader la précision de cette estimation, les estimateurs 66 et 68 sont exécutés moins fréquemment que l'estimateur 60. Par la suite, les instants d'exécution des estimateurs 66 et 68 sont notés, respectivement, k2 et k3 pour les distinguer des instants k. Ici, l'ensemble des instants k2 et l'ensemble des instants k3 sont des sous-ensembles de l'ensemble des instants k. Entre deux instants successifs k2 et k2-1 et entre deux instants successifs k3 et k3-1, il s'écoule donc plusieurs périodes $T_e$ et plusieurs instants k.

Ces estimateurs 66 et 68 sont aussi implémentés chacun sous la forme d'un filtre de Kalman. L'estimateur 66 utilise un modèle d'état 70 (figure 6) et un modèle d'observation 72 (figure 7). Dans ces modèles, les bruits $w_{2,k2}$ et $v_{2,k2}$ sont des bruits blancs gaussiens centrés. Les covariances des bruits $w_{2,k2}$ et $v_{2,k2}$ sont notées, respectivement, $Q_{2,k2}$ et $R_{2,k2}$ par la suite. Le modèle 72 d'observation permet de prédire la valeur d'une grandeur physique $u_{k2}$ directement mesurable. La grandeur physique $u_{k2}$ est ici la somme des N dernières valeurs mesurées $y_k$. Elle est définie par la relation suivante :

$$u_{k2} = \sum_{m=k-N}^{k} y_k$$

N est un entier strictement supérieur à un qui est compté comme cela sera décrit plus loin. Dans la relation ci-dessus et dans le modèle 72, l'instant k est égale à l'instant k2.

Le modèle 72 tient compte non seulement de l'état de charge $SOC_k$, de la tension $V_{D,k}$ et de l'intensité mesurée $i_k$ à l'instant k = k2 mais également des N précédentes estimations de l'estimateur 60 et des N précédentes intensités mesurées, comprises entre les instants k2 et k2-1. Le fait de prendre en compte les mesures et estimations intermédiaires entre les instants k2 et k2-1, permet d'augmenter la précision de l'estimation de la résistance interne $RO_{k2}$.

L'estimateur 68 utilise un modèle d'état 74 (figure 8) et un modèle d'observation 76. Dans les modèles 74 et 76, les bruits $w_{3,k3}$ et $v_{3,k3}$ sont des bruits blancs gaussiens centrés. Les covariances des bruits $w_{3,k3}$ et $v_{3,k3}$ sont notées respectivement $Q_{3,k3}$ et $R_{3,k3}$ par la suite. On remarquera que le modèle 76 est un modèle linéaire de sorte qu'un simple filtre de Kalman peut être utilisé pour l'estimateur 68 au lieu d'un filtre de Kalman étendu.

Le modèle 76 d'observation permet d'estimer une grandeur physique $z_{k3}$ directement mesurable. La grandeur physique $z_{k3}$ est ici la somme des N dernières intensités mesurées $i_k$. Elle est définie par la relation suivante :

$$z_{k3} = \sum_{m=k-N}^{m=k-1} i_m$$

Dans la relation ci-dessus et dans le modèle 76, l'instant k est égal à l'instant k3. Cette grandeur physique $z_{k3}$ tient compte non seulement de l'intensité mesurée $i_{k-1}$ à l'instant k-1 précédent l'instant k3 mais également de N précédentes intensités mesurées entre les instants k3 et k3-1. Ici, N est un entier strictement supérieur à un qui est compté comme cela sera décrit plus loin. Il n'est pas nécessairement égal au N introduit dans le modèle 72. Le fait de prendre en compte des mesures et estimations intermédiaires entre les instants k3 et k3-1, permet d'augmenter la précision de l'estimation de la capacité $C_{n,k3}$.

Le fonctionnement des estimateurs 60, 66 et 68 va maintenant être décrit à l'aide du procédé de la figure 10 et dans le cas particulier de l'estimation de l'état de charge de la cellule 18.

Le procédé débute par une phase 100 de réglage des différentes matrices de covariance nécessaires pour exécuter les estimateurs 60, 66 et 68. Plus précisément, lors d'une opération 102, les matrices de covariance $Q_k$ et $R_k$ de l'estimateur 60 sont automatiquement réglées à l'aide des relations suivantes : $Q_k = [N_0 G_{0,k}(N_0)]^{-1}$ et $R_k = I$, où :

- $N_0$ est un entier prédéterminé strictement supérieur à 1,
- I est la matrice identité, et
- $G_{0,k}(N_0)$ est défini par la relation suivante :

$$G_{0,k}(N_0) = \sum_{i=0}^{-} \left(F_k^T\right)^i H_k^T H_k \left(F_k\right)^i$$

$N_0$ est généralement choisi lors de la conception du système 40 puis figé une fois pour toute. Généralement, $N_0$ est inférieur à 100. Par exemple, $N_0$ est compris entre 5 et 15. Ici, $N_0$ est choisi égal à 10.

Le fait d'utiliser les relations précédentes simplifie considérablement le réglage des matrices $Q_0$ et $R_0$ ainsi que le réglage des matrices $Q_k$ et $R_k$ comme on le verra pas la suite. En effet, le seul paramètre à choisir est la valeur de l'entier $N_0$.

Lors d'une opération 104, les covariances $Q_{2,0}$ et $R_{2,0}$ sont aussi réglées. Par exemple, $Q_{2,0}$ est choisi égal à $[(\beta*RO^{ini})/(3*N^C_{eol}*N_S)]^2$, où :

- $\beta$ est une constante choisie supérieure ou égale à 0,3 ou 0,5 et, de préférence, supérieur à 0,8 et généralement inférieure à trois,
- $N^c_{eol}$ est le nombre prévu de cycles de charge et de décharge de la cellule 18 avant que celle-ci atteigne sa fin de vie, et
- $N_S$ est le nombre de fois où la résistance interne est estimée par cycle de charge et de décharge de la cellule18.

La constante $\beta$ représente, exprimée en pourcentage divisé par 100, l'écart entre la valeur de la résistance interne initiale $RO^{ini}$ et sa valeur en fin de vie. Typiquement, $\beta$ est fixé par l'utilisateur ou mesuré expérimentalement. $N^c_{eol}$ est un nombre de cycles qui peut être mesuré expérimentalement ou obtenu à partir des données du constructeur de la cellule 18. $N_S$ est fixé par le procédé d'estimation de l'état de charge mis en oeuvre par le calculateur 44. Dans ce mode de réalisation, comme on le verra plus loin, la résistance interne est estimée une seule fois par cycle. Par conséquent, $N_S$ est pris égale à 1.

A titre d'illustration, la covariance $R_{2,0}$ est choisie égale à $(2\varepsilon_m U_{max}/300)^2$, où $\varepsilon_m$ est l'erreur maximale du voltmètre 34 exprimée en pourcentage.

Par la suite, les covariances $Q_{2,k2}$ et $R_{2,k2}$ sont considérées comme étant constantes et égales, respectivement, à $Q_{2,0}$ et $R_{2,0}$.

Lors d'une opération 106, les covariances $Q_{3,0}$ et $R_{3,0}$ sont réglées. Par exemple, la covariance $Q_{3,0}$ est prise égale à $[y*C_n^{ini}/(3*N^C_{eol}*N_S)]^2$, où y représente, exprimée en pourcentage divisé par 100, l'écart entre la capacité $C_n^{ini}$ et la capacité de la cellule 18 en fin de vie. y est une constante choisie par l'utilisateur entre 0,05 et 0,8 et, de préférence, entre 0,05 et 0,3. Ici, y = 0,2.

La covariance $R_{3,0}$ est par exemple choisie égale à $[2*\varepsilon_{im}*I_{max}/300]^2$, où $\varepsilon_{im}$ est l'erreur maximale de l'ampèremètre 36 exprimé en pourcentage.

Par la suite, les covariances $Q_{3,k3}$ et $R_{3,k3}$ sont considérées comme étant constantes et prises égales, respectivement, à $Q_{3,0}$ et $R_{3,0}$.

Une fois les matrices de covariance réglées, l'estimation de l'état de charge de la cellule 18 peut commencer.

Lors d'une phase 110, à chaque instant k, le voltmètre 34 et l'ampèremètre 36 mesurent, respectivement, la valeur $y_K$ et l'intensité $i_k$ et ces mesures sont immédiatement acquises par le système 40 et enregistrées dans la mémoire 42. La phase 110 est réitérée à chaque instant k.

En parallèle, l'estimateur 60 exécute une phase 114 d'estimation de l'état de charge à l'instant k de la cellule 18.

Pour cela, lors d'une étape 116, l'estimateur 60 calcule une prédiction $SÔC_{k/k-1}$ et une prédiction $V_{D,k/k-1}$ de, respectivement, l'état de charge de la cellule 18 et la tension $V_D$ aux bornes du circuit 54 à l'instant k. Dans les notations utilisées ici, l'indice k/k-1 indique que cette prédiction est faite en prenant en compte seulement les mesures réalisées entre les instants 0 et k-1. On parle alors de prédiction a priori. L'indice k/k indique que la prédiction à l'instant k prend en compte l'ensemble des mesures réalisées entre les instants 0 et k. On parle alors de prédiction a posteriori. Les prédictions $SÔC_{k/k-1}$ et $V_{D,k/k-1}$ sont calculées à l'aide du modèle 62, de l'intensité mesurée $i_{k-1}$ et de la capacité $C_{n,k3}$. On notera que dans le modèle 62, la matrice $F_{k-1}$ de transition d'état est constante quel que soit k et n'a donc pas besoin d'être réévaluée à chaque instant k.

Lors d'une étape 117, l'estimateur 60 calcule également la prédiction $P_{k/k-1}$ d'une matrice de covariance d'erreur d'estimation sur le vecteur d'état $x_k$. Typiquement, cela est réalisé à l'aide de la relation suivante :

$$P_{k/k-1} = F_{k-1}P_{k-1/k-1}F_{k-1}^T + Q_{k-1}$$

Ces différentes matrices $F_{k-1}$, $P_{k-1/k-1}$ et $Q_{k-1}$ ont déjà été précédemment définies.

Ensuite, lors d'une étape 118, l'estimateur 60 construit la matrice Hk en linéarisant le modèle 64 autour des prédictions $SÔC_{k/k-1}$ et $V_{D,k/k-1}$.

Lors d'une étape 120, les matrices de covariance $Q_k$ et $R_k$ sont automatiquement mises à jour. Ici, pour cela, l'étape 120 est identique à l'opération 102 en prenant en compte cette fois-ci la matrice $H_k$ construite lors de l'étape 118.

Après cela, lors d'une étape 122, l'estimateur 60 corrige les prédictions $SÔC_{k/k-1}$ et $V_{D,k/k-1}$ en fonction d'un écart entre la valeur mesurée $y_k$ et une valeur $\hat{y}_k$ prédite à partir du modèle 64. Cet écart est connu sous le nom de « innovation ». Cette étape 122 comprend typiquement :

- une opération 124 de calcul de la prédiction $\hat{y}_k$, puis
- une opération 126 de correction des prédictions $SÔC_{k/k-1}$ et $V_{D,k/k-1}$ et de la matrice $P_{k/k-1}$ pour obtenir les prédictions corrigées $SÔC_{k/k}$, $V_{D,k/k}$ et $P_{k/k}$.

Lors de l'opération 124, la prédiction $\hat{y}_k$ est calculée à l'aide du modèle 64 dans lequel la valeur de l'état de charge est prise égale à $SÔC_{k/k-1}$ et la valeur de la tension $V_{D,k}$ est prise égale à $V_{D,k/k-1}$. L'écart entre la valeur mesurée $y_k$ et sa prédiction $\hat{y}_k$ est notée Ek par la suite.

De nombreuses méthodes existent pour corriger les estimations à priori $SÔC_{k/k-1}$ et $V_{D,k/k-1}$ à partir de l'innovation $E_k$. Par exemple, lors de l'opération 126, ces estimations sont corrigées à l'aide du gain de Kalman $K_k$. Le gain $K_k$ est donné par la relation suivante $K_k = P_{k/k-1}H^T_k(H_kP_{k/k-1}H^T_k+R_k)^{-1}$. Ensuite, les prédictions a priori sont corrigées à l'aide de la relation suivante : $X_{k/k} = x_{k/k-1} + K_kE_k$.

La matrice $P_{k/k-1}$ est corrigée à l'aide de la relation suivante : $P_{k/k} = P_{k/k-1} - K_kH_kP_{k/k-1}$.

Les étapes 116 à 122 sont réitérées à chaque instant k où une nouvelle estimations de l'état de charge de la cellule 18 doit être réalisée. Lors de chaque nouvelle itération, le vecteur d'état $x_{k-1}$ est initialisé avec les valeurs obtenues lors de la précédente itération de la phase 114 pour la cellule 18.

En parallèle, lors d'une étape 130, le calculateur 44 compare chaque nouvelle mesure de l'intensité $i_k$ à un seuil $SH_i$ de courant prédéterminé. Tant que l'intensité mesurée ne dépasse pas ce seuil $SH_i$, l'exécution de l'estimateur 66 et inhibée. À l'inverse, dès que l'intensité $i_k$ mesurée dépasse ce seuil $SH_i$, alors l'estimateur 66 est immédiatement exécuté. Le seuil $SH_i$ est généralement supérieur à $I_{max}/2$ et, avantageusement supérieur à $0,8*I_{max}$ ou $0,9*I_{max}$.

L'estimateur 66 exécute une phase 140 d'estimation de la résistance interne $RO_{k2}$ à l'instant k2. Ici, l'instant k2 est égal à l'instant k où l'intensité $i_k$ franchit le seuil $SH_i$.

Pour cela, lors d'une étape 142, l'estimateur 66 calcule la prédiction a priori $R\hat{O}_{k/k-1}$ de la résistance interne à partir du modèle 70.

Ensuite, lors d'une étape 144, l'estimateur 66 calcule la prédiction $P_{2,k2/k2-1}$ de la matrice de covariance de l'erreur d'estimation sur la résistance interne. Par exemple, cette prédiction est calculée à l'aide de la relation suivante : $P_{2,k2/k2-1} = P_{2,k2-1/k-1} + Q_{2,0}$. On notera qu'ici, le modèle 72 est une fonction linéaire de la variable d'état. Il n'est donc pas nécessaire de la linéariser au voisinage de la prédiction $R\hat{O}_{k2/k2-1}$ pour obtenir la matrice $H_{2,k2}$. Ici, cette matrice $H_{2,k2}$ est égale à -N.

Lors d'une étape 148, l'estimateur 66 corrige la prédiction $R\hat{O}_{k2/k2-1}$ en fonction de l'écart entre la grandeur physique mesurée $u_{k2}$ et une prédiction $\hat{u}_{k2}$ de cette même grandeur physique. Ici, N est une constante prédéterminée choisie strictement à un et, de préférence, supérieure à 10 ou 30. La grandeur $u_{k2}$ est acquise par l'estimateur 66 au fur et à mesure que les valeurs $y_k$ sont mesurées et acquises.

Plus précisément, lors d'une opération 150, le calculateur 44 acquière la grandeur mesurée $u_{k2}$ et calcule la prédiction $\hat{u}_{k2}$. L'acquisition de la grandeur $u_{k2}$ est réalisée en sommant les N dernières mesures de la valeur mesurée $y_k$. La prédiction $\hat{u}_{k2}$ est calculée à l'aide du modèle 72. Dans ce modèle 72, la valeur $RO_{k2}$ est prise égale à la valeur $RO_{k2/k2-1}$ précédemment calculée.

Ensuite, lors d'une opération 152, l'estimateur 66 corrige la prédiction $R\hat{O}_{k2/k2-1}$ en fonction de l'innovation $E_{k2}$. L'innovation $E_{k2}$ est égale à l'écart entre la grandeur mesurée $u_{k2}$ et la grandeur prédite $\hat{u}_{k2}$. Par exemple, lors de l'opération 152, la même méthode que celle mise en oeuvre lors de l'opération 126 est employée. Ainsi, cette opération 152 n'est pas décrite ici plus en détail. Ensuite, la nouvelle estimation $RO_{k2/k2}$ est utilisée lors des exécutions suivantes de l'estimateur 60 à la place de la précédente estimation $RO_{k2-1/k2-1}$.

Le fait de déclencher l'exécution de l'estimateur 66 uniquement lorsque l'intensité mesurée $i_k$ est élevée permet d'accroître la précision de l'estimation de la résistance interne tout en diminuant en même temps la puissance de calcul nécessaire pour mettre en oeuvre ce procédé. En effet, la précision de la mesure de ampèremètre est plus élevée lorsque l'intensité $i_k$ est plus élevée.

Également en parallèle des phases 110 et 114, le procédé comporte une étape 160 lors de laquelle à chaque instant k, l'estimation $SOC_k$ est comparée à un seuil haut prédéterminé $SH_{soc}$. Si l'estimation $SOC_k$ descend en dessous de ce seuil $SH_{soc}$, alors le procédé se poursuit immédiatement par des étapes 162 et 164. Dans le cas contraire, l'étape 160 est réitérée au prochain instant k. Typiquement, le seuil $SH_{soc}$ est compris entre 90 % et 100 %.

Lors de l'étape 162, le calculateur 44 commence par initialiser un compteur à zéro puis l'incrémente de 1 à chaque nouvelle mesure de l'intensité $i_k$ depuis le début de cette étape. De plus, à chaque instant k, l'intensité mesurée $i_k$ et l'estimation $SOC_k$ générée au même instant sont enregistrées, associée à cet instant k, dans une base de données.

En parallèle de l'étape 162, lors de l'étape 164, le calculateur 44 compare chaque nouvelle estimation $SOC_k$ à un seuil prédéterminé $SL_{soc}$. Le seuil $SL_{soc}$ est par exemple compris entre 0 % et 10 %. Tant que l'estimation $SOC_k$ reste supérieure à ce seuil $SL_{soc}$, l'étape 162 est réitérée à l'instant k suivant. Dans le cas contraire, dès que l'estimation $SOC_k$ pour la cellule 18 descend en dessous de ce seuil $SL_{soc}$ alors, le calculateur 44 déclenche immédiatement l'exécution de l'estimateur 68 et arrête d'incrémenter le compteur. Ainsi, tant que ce seuil $SL_{soc}$ n'est pas franchi, l'exécution de l'estimateur 68 est inhibée.

L'estimateur 68 estime, lors d'une phase 166, capacité $C_{n,k3}$ à l'instant k3. L'instant k3 est donc égal à l'instant k où l'exécution de l'estimateur 68 est déclenchée.

Comme pour la phase 140, étant donné que l'estimateur 68 n'est pas exécuté à chaque instant k, l'instant k3-1 ne correspond pas à l'instant k-1. Au contraire, les instants k3 et k3-1 sont séparés par un intervalle de temps supérieur ou égal à $NT_e$ où N est le nombre compté lors de l'étape 162.

Les paramètres du filtre de Kalman de l'estimateur 68 sont initialisés avec les valeurs précédentes de ces paramètres obtenus à l'issue de la précédente itération à l'instant k3-1 de la phase 166.

La phase 166 comprend :

- le calcul, lors d'une étape 170, de la prédiction $C_{n,k3/k3-1}$ à l'aide du modèle 74,
- le calcul, lors d'une étape 172, de la prédiction $P_{3,k3/k3-1}$ de la matrice de covariance de l'erreur d'estimation de la capacité, et

- la correction, lors d'une étape 174, des prédictions $C_{n,k3/k3-1}$ et $P_{3,k3/k3-1}$.

Lors des étapes 172 et 174, la matrice d'observabilité $H_{3,k3}$ est égale à $[(SOC_k - SOC_{k-N})]*3600/(NT_e)$. N est ici le nombre d'instants k écoulés entre l'instant où l'état de charge estimé est descendu en dessous du seuil $SH_{soc}$ et l'instant où l'état de charge estimé est descendu en dessous du seuil $SL_{soc}$. La valeur N est égale à la valeur comptée lors de l'étape 162.

L'étape 174 comprend une opération 176 d'acquisition de la grandeur physique mesurée $z_{k3}$ et de calcul de la prédiction $\hat{z}_{k3}$ de la grandeur $z_{k3}$. L'acquisition de la grandeur $z_{k3}$ consiste ici à calculer la somme des N dernières intensités mesurées entre les instants k-1 et k-N. La prédiction $\hat{z}_{k3}$ est obtenue à partir du modèle 76.

Ensuite, lors d'une opération 178, l'estimateur 68 corrige la prédiction $c_{n,k3/k3-1}$ en fonction de l'écart entre la grandeur mesurée $z_{k3}$ et la grandeur prédite $\hat{z}_{k3}$ pour obtenir l'estimation a posteriori de la capacité $C_{n,k3/k3}$. Cette correction est par exemple réalisée comme décrit lors de l'étape 126.

Ensuite, la capacité $C_{n,k3/k3}$ est transmise à l'estimateur 60 qui l'utilise pour estimer l'état de charge de la cellule 18 aux instants suivants.

Le fait de déclencher l'exécution de l'estimateur 68 uniquement après que la cellule 18 se soit en grande partie déchargée permet d'accroître la précision de l'estimation tout en diminuant en même temps la puissance de calcul nécessaire pour mettre en oeuvre ce procédé.

À l'issue de la phase 166, lors d'une étape 180, le calculateur calcule l'état de santé $SOH_{k3}$ l'instant k3 à l'aide de la formule suivante : $SOH_{k3} = C_{n,k3}/C_n^{ini}$.

La figure 11 représente un procédé de détermination de l'état de charge de la batterie 10. À l'instant k, l'état de charge de la batterie 10 est déterminé à partir de l'état de charge de chacune des cellules de cette batterie. Par exemple, cela est réalisé de la façon suivante. Lors d'une étape 190, le calculateur 44 détermine l'état de charge de chaque étage de la batterie en additionnant l'état de charge de chaque cellule de cet étage.

Ensuite, lors d'une étape 192, l'état de charge de la batterie est pris égal au plus petit des états de charge d'un étage déterminé lors de l'étape 190.

Comme illustré par le procédé de la figure 11, la détermination de l'état de charge de charge de la batterie à chaque instant k nécessite de disposer d'une estimation de l'état de charge pour chacune des cellules à l'instant k. Une première solution consiste donc à exécuter en parallèle, pour chacune des cellules, le procédé d'estimation de la figure 10 en exécutant à chaque instant k la phase 114. Toutefois, pour limiter la puissance de calcul requise, sans dégrader la précision de l'état de charge déterminé pour la batterie, il est aussi possible de planifier l'exécution des estimations des états de charge des cellules comme décrit en référence au procédé de la figure 12.

Le procédé de la figure 12 est décrit dans le cas simplifié où l'on utilise seulement trois niveaux de priorité, appelés respectivement niveau élevé, niveau moyen et niveau faible de priorité. De plus, on prend comme hypothèse que l'état de charge d'une cellule dont le niveau de priorité est élevé doit être estimé à chaque instant k et donc à une fréquence $f_e$. L'état de charge d'une cellule dont le niveau de priorité est moyen doit seulement être estimé avec une fréquence trois fois plus faible et donc à une fréquence $f_e/3$. Enfin, l'état de charge des cellules de niveau de priorité faible doit être estimé à une fréquence dix fois plus faible est donc à une fréquence $f_e/10$. Dans cet exemple, pour les niveaux de priorité élevé et moyen, il existe un nombre de places limités connus à l'avance. En d'autres termes, le nombre de cellules affectées au niveau de priorité élevé est limité à un nombre maximal prédéterminé à l'avance. Il en est de même pour le nombre de cellules affectés au niveau de priorité moyen.

Pour planifier les instants auxquels doivent être rafraîchies les estimations de l'état de charge de chacune des cellules, le calculateur commence par affecter, lors d'une étape 198, un niveau de priorité à chaque cellule.

L'étape 198 débute par une opération 200 lors de laquelle le système 40 acquiert la valeur mesurée $y_k$ de la tension entre les bornes de chacune des cellules.

Ensuite, lors d'une opération 202, si la valeur mesurée $y_k$ est au-dessus d'un seuil haut $SH_y$ ou, au contraire, en dessous d'un seuil bas $SL_y$, alors le calculateur 44 affecte à cette cellule le niveau de priorité élevé tant qu'il reste assez de place dans ce niveau. Le seuil $SH_y$ est supérieur ou égal à $0,9*U_{max}$ et, de préférence, supérieur à $0,95*U_{max}$. Le seuil $SL_y$ est quant à lui supérieur ou égal à $U_{min}$, et inférieur à $1,1*U_{min}$, ou $1,05*U_{min}$. Il est important de rafraîchir fréquemment l'estimation de l'état de charge des cellules dont la tension est proche de $U_{max}$ ou au contraire proche de $U_{min}$. En effet, une erreur sur l'estimation de l'état de charge d'une cellule dans une telle situation peut conduire à une dégradation des propriétés électriques et mécaniques de cette cellule.

Ensuite, pour les autres cellules, lors d'une opération 204, le calculateur 44 calcule l'écart de tensions entre la valeur mesurée actuelle $y_k$ et une précédente valeur $y_{k-x}$, où X est un entier prédéterminé supérieur ou égal à un et généralement inférieur à 5 ou 10. Ici, X = 1.

Lors d'une opération 205, le calculateur 44 identifie des cellules jumelles. Des cellules sont considérées comme étant « jumelles » si, au même instant k, elles ont le même écart de tensions et la même valeur mesurée $y_k$. Pour cela, lors de l'étape 205, le calculateur 44 compare l'écart de tensions et la valeur mesurée $y_k$ pour une cellule aux écarts de tensions et aux valeurs mesurées $y_k$ pour les autres cellules au même instant afin d'identifier, parmi ces autres cellules, la ou les cellules jumelles de cette cellule. L'identifiant de cette cellule et les identifiants de la ou des cellules identifiées comme étant ses jumelles sont alors regroupés dans un ensemble qui est enregistré dans la mémoire 42. La comparaison ci-dessus est par exemple réalisée pour chacune des cellules de la batterie 10 dont l'identifiant n'a pas déjà été incorporé dans l'un des ensembles enregistrés de cellules jumelles. Par la suite, un niveau de priorité est affecté à une seule des cellules de chaque ensemble de cellules jumelles. Ainsi, l'opération 206 et les étapes 208 et 210 suivantes sont réalisées uniquement pour les cellules qui n'ont pas de cellule jumelle et pour une seule cellule de chaque ensemble de cellules jumelles.

Lors d'une opération 206, le calculateur classe les cellules par ordre décroissant de valeur absolue de l'écart calculé lors de l'opération 204. Puis, il affecte aux premières cellules de ce classement les places restantes associées à des niveaux de priorité élevés. Ensuite, il affecte les places restantes associées à un niveau de priorité moyen aux cellules suivantes dans ce classement. Enfin, il affecte aux dernières cellules de ce classement le niveau de priorité faible.

Une fois qu'un niveau de priorité a été affecté à chaque cellule, lors d'une étape 208, le calculateur 44 planifie les instants de rafraîchissement des estimations des états de charge des cellules en fonction de leur niveau de priorité. L'étape 208 est réalisée de manière à respecter la fréquence de rafraîchissement des estimations associée à chacun des niveaux de priorité. Pour cela, par exemple, le calculateur 44 réserve d'abord les instants auxquels les estimations des cellules de niveau de priorité élevé doivent être rafraîchies. Ensuite, il réserve les instants auxquels les estimations de l'état de charge des cellules de niveau de priorité moyen doivent être rafraîchies en tenant compte des instants de rafraîchissement déjà réservés. Enfin, il procède de même avec les cellules affectées d'un niveau de priorité faible.

Pour illustrer cela, on suppose qu'un niveau de priorité élevé a été affecté à la cellule 18, qu'un niveau de priorité moyen a été affecté aux cellules 19 et 20 et qu'un niveau de priorité faible a été affecté à la cellule 21. De plus, on impose que pendant une période $T_e$, le calculateur exécute au plus deux fois la phase 114 du procédé de la figure 10. Le résultat obtenu avec ces hypothèses est représenté sur la figure 13. Sur cette figure, les instants k à k+11 ont été représentés en abscisse. Au-dessus de chacun de ces instants k, deux cases symbolisent le fait que le calculateur 44 peut, à chaque instant k, exécuter deux fois la phase 114 du procédé de la figure 10. Dans chacune de ces cases, on a indiqué le numéro de la cellule pour lequel la phase 114 est exécutée. Lorsque aucun numéro ne figure dans cette case, cela signifie que le procédé de la figure 10 n'est pas exécuté et donc que la puissance de calcul épargnée peut être utilisée à d'autres fins comme, par exemple, l'exécution des estimateurs 66 et 68.

Enfin, lors d'une étape 210, pour chaque cellule affectée d'un niveau de priorité, le calculateur 44 exécute la phase 114 à l'instant planifié pour cette cellule. En dehors de ces instants planifiés, le calculateur inhibe l'exécution complète de la phase 114 pour cette cellule. De même, l'exécution de la phase 114 pour les cellules jumelles auxquelles aucun niveau de priorité n'a été affecté est également inhibé.

En parallèle, lors d'une étape 212, pour chaque cellule jumelle à laquelle aucun niveau de priorité n'a été affecté, l'estimation de l'état de charge de cette cellule est prise égale à la dernière estimation calculée lors de l'étape 210 pour une cellule jumelle de cette cellule. Ainsi, la phase 114 est exécutée pour une seule des cellules jumelles. Cela permet de réduire la puissance de calcul requise pour déterminer l'état de charge de batterie sans dégrader la précision de cette détermination.

Éventuellement, en parallèle de l'étape 210, à chaque instant k, le calculateur 44 exécute aussi une étape 214 de prédiction de l'état de charge pour chacune des cellules qui ne sont pas traitées lors de l'étape 210 à cet instant k. L'étape 214 consiste à exécuter seulement l'étape 116 de prédiction, sans exécuter l'étape 122 de correction, pour toutes les cellules pour lesquelles, au même instant, la phase 114 complète d'estimation n'est pas exécutée. En effet, l'étape 116 de prédiction est beaucoup moins gourmande en puissance de calcul que l'étape 122 et peut donc être exécutée, par exemple, à chaque instant k. Ainsi, lorsque l'étape 214 est mise en oeuvre, on dispose à chaque instant k d'une nouvelle estimation de l'état de charge pour chacune des cellules de la batterie.

Les étapes 198 et 208 sont réitérées à intervalle régulier pour mettre à jour le niveau de priorité affecté à chacune de ces cellules et donc les fréquences de rafraîchissement de l'estimation de l'état de charge de ces cellules. Ce procédé de planification des instants de rafraîchissement des estimations des états de charge des cellules permet de limiter la puissance de calcul requise sans pour autant dégrader la précision de l'état de charge déterminé pour la batterie. En effet, le procédé de la figure 12 exploite le fait que les cellules dont les écarts de tensions sont faibles sont des cellules qui se déchargent ou se chargent peu et donc dont l'état de charge ne varie pas rapidement. On peut donc estimer l'état de charge de ces cellules à une fréquence moins élevée sans que cela dégrade la précision de l'état de charge déterminé pour la batterie.

Au cours de l'exécution des procédés des figures 10 et 11, à chaque fois que l'état de charge $SOC_k$ d'une cellule à un instant donné doit être utilisé pour un calcul, l'état de charge $SOC_k$ est pris égal au dernier état de charge estimé ou prédit pour cette cellule. Autrement dit, on considère que l'état de charge reste constant entre deux instants successifs où il est estimé ou prédit.

On notera également qu'à chaque fois que le calculateur 44 exécute la phase 114 d'estimation pour une cellule, il récupère les informations nécessaires pour cette exécution à partir des valeurs obtenues à l'issue de la précédente exécution de cette phase pour la même cellule. C'est notamment le cas par exemple pour les variables d'état. On notera cependant que l'instant d'exécution précédent n'est alors pas nécessairement l'instant k-1 mais peut être l'instant k-3 ou k-10 selon le niveau de priorité affecté à cette cellule.

De nombreux autres modes de réalisation du procédé d'estimation de l'état de charge d'une cellule sont possibles. Par exemple, la figure 14 représente un autre agencement d'estimateurs. Cet autre agencement est identique à celui de la figure 3 sauf que les estimateurs 66 et 68 sont remplacés par un seul estimateur 230. L'estimateur 230 estime simultanément la capacité et la résistance interne de la cellule 18. L'estimateur 230 est exécute moins fréquemment que l'estimateur 60. Ici, on note k4 les instants d'exécution de l'estimateur 230 et donc $C_{n,k4}$ et $RO_{k4}$ la capacité et la résistance interne estimée à l'instant k4. L'ensemble des instants k4 est un sous-ensemble des instants k.

L'estimateur 230 estime en même temps la capacité $C_{n,k4}$ et la résistance interne $RO_{k4}$. Cet estimateur 230 implémente un filtre de Kalman qui utilise un modèle d'état 232 (figure 15) et un modèle d'observation 234 (figure 16).

Le fonctionnement de cet estimateur 230 va maintenant être décrit en référence au procédé de la figure 17 et dans le cas particulier de la cellule 18. Ce procédé de la figure 17 est identique au précédé de la figure 10 sauf que les étapes 130 à 174 sont remplacées par des étapes 240, 242, 244 et une phase 246 d'estimation de la capacité et de la résistance interne.

Lors de l'étape 240, le calculateur 44 compare à chaque instant k la valeur mesurée $y_k$ à un seuil haut $SH_{y2}$. Typiquement, ce seuil $SH_{y2}$ est supérieur ou également à $0,8*U_{max}$ ou $0,9*U_{max}$. Les étapes 242 et 244 sont exécutées uniquement si valeur mesurée $y_k$ descend en dessous de ce seuil $SH_{y2}$.

Lors de l'étape 242, la calculateur 44 commence par initialiser un compteur à zéro puis incrémente ce compteur de 1 à chaque nouvel instant k. De plus, à chacun de ces instants k, l'intensité mesurée $i_k$, la valeur $y_k$, l'état de charge $SOC_k$ et la tension estimée $V_{D,k}$ sont enregistrés, associés à cet instant k, dans une base de données.

En parallèle de l'étape 242, lors de l'étape 244, le calculateur 44 compare, à chaque instant k, la nouvelle valeur mesurée $y_k$ à un seuil bas $SL_{y2}$ de tension. Ce seuil $SL_{y2}$ est inférieur ou égal à $1,2*U_{min}$ ou à $1,1*U_{min}$ et supérieur ou égal à $U_{min}$.

Dès que la valeur mesurée $y_k$ descend en dessous du seuil $SL_{y2}$, l'incrémentation du compteur lors de l'étape 242 est arrêtée et l'exécution de l'estimateur 230 est déclenchée. À l'inverse, tant que la valeur mesurée $y_k$ reste supérieure à ce seuil $SL_{y2}$, l'exécution de l'estimateur 230 est inhibée.

L'estimateur 230 exécute la phase 246. Comme précédemment, on note que les instants k4 et $k_4$-1 sont séparés par un intervalle de temps supérieur ou également à $NT_e$, où N est la valeur du compteur incrémenté lors de l'étape 242. Le fonctionnement de l'estimateur 230 se déduit du fonctionnement décrit précédemment pour les estimateurs 66 et 68. Il ne sera donc pas décrit ici plus en détail.

D'autres modèles électriques et donc d'autres modèles d'état peuvent être utilisés pour estimer l'état de charge de la cellule 18. Par exemple, dans une variante simplifiée, le circuit 54 est omis. À l'inverse, un modèle électrique plus complexe peut contenir plusieurs circuits RC parallèles raccordés électriquement en série les uns avec les autres. Le modèle d'état de la cellule 18 doit alors être modifié en conséquence pour correspondre à ce nouveau modèle électrique de la cellule. Toutefois, tout ce qui a été décrit précédemment s'applique sans difficulté avec un tel modèle d'état modifié. Pour des exemples de modèles d'état modifiés, le lecteur peut se référer à la demande WO2006057468.

Les paramètres $R_D$ et $C_D$ du modèle 50 peuvent aussi être estimé au lieu d'être considérés comme des paramètres constants prédéterminés. A cet effet, ces deux paramètres $R_D$ et $C_D$ sont par exemple introduits dans le vecteur d'état $x_k$ qui devient alors $[SOC_k, V_{D,k}, R_{D,k}$ et $C_{D,k}]^T$. Par exemple, le modèle d'état est modifié pour incorporer les deux équations suivantes $R_{D,k+1} = R_{D,k}$ et $C_{D,k+1} = C_{D,k}$.

Le vecteur d'état $x_k$ peut aussi être complété par la température de la cellule de manière à estimer cette température en même temps que l'état de charge de cette cellule.

La cellule peut aussi être équipé de capteurs supplémentaires tel qu'un capteur de température. Dans ce cas, le modèle d'observation est modifié pour tenir compte de ces grandeurs physiques mesurées supplémentaires. Le lecteur peut se référer à la demande WO2006057468 pour des exemples de modèles d'observation modifiés.

D'autres modèles électriques possibles pour modéliser la cellule électrique sont également présentés dans la partie 2 de Plett 2004, au chapitre 3.3.

L'ajustement automatique en continu des matrices de covariance $R_k$ et $Q_k$ peut être réalisé différemment. Par exemple, la méthode dite de « Covariance Matching » décrite dans l'article suivant peut être appliquée : Mehra, R.K : « On the identification of variances and adaptative Kalman Filtering », Automatic Control, IEEE Transaction on, Volume 15, n°2, pages 175-184, avril 1970. Cette méthode s'applique après un réglage initial des matrices $R_0$ et $Q_0$, par exemple, comme décrit lors de l'opération 102.

Dans une autre variante, les matrices $Q_0$, $R_0$, $Q_k$ et $R_k$ ne sont pas réglées comme décrit en référence aux opérations 102 et 120. Par exemple, ces matrices sont réglées en mettant en oeuvre une méthode conventionnelle. Dans un cas simplifié, elles sont constantes. Par exemple, la matrice $R_0$ est alors réglée à partir des données fournies par le constructeur des capteurs ou à partir de tests réalisés sur ces capteurs et la matrice $Q_0$ par essais successifs.

L'étape 122 de correction de la prédiction peut être réalisée différemment. Par exemple, dans une méthode préférée, la correction de la prédiction de l'état de charge et de la tension $V_{D,k}$, est réalisée en minimisant une fonction de coût J quadratique qui comporte deux termes :

- un terme lié à l'erreur de prédiction de la valeur mesurée, et
- un autre terme lié à l'erreur d'estimation du vecteur d'état.

Cette méthode est décrite en détail au chapitre 10.5.2 du livre suivant : Y. Bar-Shalom, et Al. : « Estimation With Applications to Tracking and Navigation, Theory Algorithms and Software », Wiley Inter-science, 2001.

Dans une autre variante, l'estimateur 60 n'est pas implémenté sous la forme d'un filtre de Kalman. Par exemple, l'état de charge est estimée en modélisant son évolution au cours du temps sous la forme d'un filtre RII (Réponse Impulsionnelle Infinie) dont les coefficients sont estimés par la méthode RLS (Recursive Least Square).

D'autres modèles d'état peuvent être utilisés pour estimer la résistance interne et la capacité de la cellule. Par exemple, le modèle 232 peut être remplacé par un modèle 250, représenté sur la figure 18. Dans le modèle 250, $\alpha$, $\beta$ et y sont des constantes dont les valeurs sont obtenues à partir de données du constructeur de la cellule ou mesurées expérimentalement. Typiquement :

- $\alpha$ est égal à 1 à plus ou moins 30 % près ou 10 % près,
- $\beta$ est également égal à 1 à plus ou moins 30 % ou 10 %, et
- y est typiquement compris entre 0,1 et 0,5. Par exemple, y est égal à 0,2 à plus ou moins 30 % près ou 10 %.

Dans le modèle 250, $N^c_k$ est égal au nombre de cycles de charge/décharge de la cellule réalisés avant l'instant k. Ce nombre de cycles est par exemple mesuré en comptant le nombre de fois où l'état de charge de la cellule descend en dessous du seuil haut $SH_{soc}$ puis en dessous du seuil bas $SL_{soc}$. $w^a_{d,k}$ est un bruit blanc gaussien centré. y est l'écart, exprimé en pourcentage divisé par 100, entre la capacité initiale $C_n^{ini}$ de la cellule et sa capacité en fin de vie. Ce modèle prend en compte le fait :

- que la résistance interne augmente au fur et à mesure que la cellule vieillit, et
- que la capacité de la cellule diminue au fur et à mesure que cellule vieillit.

De façon similaire, le modèle d'état 70 peut être remplacé par le modèle d'état suivant : $RO_{k2+1} = (\alpha+\beta N^C_{k2}/N^C_{EOL})RO_{k2}+w_{2, k2}$, où les différents symboles de ce modèle ont déjà été précédemment définis.

Le modèle d'état 74 peut être remplacé par le modèle d'état suivant : $C_{n,k3+1} = (1-yN^C_{k3}/N^C_{EOL})C_{n, k3}+v_{3,k3}$ où les différents symboles de ce modèle ont déjà été précédemment définis.

Selon le modèle d'observation utilisé par l'estimateur 68, la grandeur $z_{k3}$ peut être calculée différemment. Par exemple, la grandeur $z_{k3}$ est égale à la somme des N dernières intensités mesurées entre les instants k et k-N+1. Dans ce cas, lorsque N est égal à 1, $z_{k3} = i_{k3}$.

Ce qui a été décrit précédemment pour l'initialisation des matrices de covariance $Q_k$ et $R_k$ peut aussi être appliqué pour l'initialisation des matrices de covariance des estimateurs 68 et 230.

En variante, l'estimateur 68 n'est pas implémenté sous la forme d'un filtre de Kalman. Par exemple, la capacité est estimée en modélisant son évolution au cours du temps sous la forme d'un filtre RII (Réponse Impulsionnelle Infinie) dont les coefficients sont estimés par la méthode RLS (Recursive Least Square).

Les procédés des figures 10 et 17 peuvent être simplifiés en prenant N égal à une constante prédéterminée. Dans ce cas, N n'est pas compté et les étapes 160, 162, 240 et 242 peuvent être omises. Par exemple, N est choisi égale à un ou, au contraire, strictement supérieur à 1 ou 5 ou 10.

Dans une autre variante, à chaque instant k entre les instants k3 et k3-1, seule l'étape 170 de calcul d'un prédiction $C_{n,k}$ est exécutée mais l'étape 174 de correction de cette prédiction n'est pas exécutée. Ainsi, on obtient une nouvelle prédiction de la capacité de la cellule à chacun de ces instants k tout en limitant la puissance de calcul requise. De façon similaire, à chaque instant k entre les instants k4 et k4-1, seule l'étape de calcul des prédictions de la capacité et de la résistance interne est exécutée sans exécuter l'étape de correction de ces prédictions. Ainsi, dans ces variantes, la capacité de la cellule est prédite à chaque instant k mais cette prédiction est corrigée uniquement aux instants k3 ou k4. L'algorithme d'estimation de cette capacité n'est donc que partiellement exécuté entre les instants k3 et k3-1 ou k4 et k4-1 et complètement exécuté uniquement à l'instant k3 ou k4.

A chaque instant k entre les instants k3 et k3-1 ou entre les instants k4 et k4-1, la capacité peut être estimée en exécutant un premier algorithme, puis à l'instant k3 ou k4, la capacité est estimée en exécutant un second algorithme différent du premier algorithme et nécessitant une puissance de calcul plus importante. Les premier et second algorithmes ne correspondent pas nécessairement, comme décrit précédemment, respectivement, à la seule étape 170 et à la phase 166 ou 246 d'un filtre de Kalman. Il peut aussi s'agir de deux algorithmes d'estimation complètement différents.

L'étape 166 ou 246 d'estimation de la capacité de la cellule peut être déclenchée en réponse au franchissement d'un seuil sur l'état de charge, comme décrit en référence à la figure 10, ou en réponse au franchissement d'un seuil sur la tension comme décrit en référence à la figure 17. Ces étapes 166 et 246 peuvent aussi être déclenchées en réponse au franchissement d'un seuil de quantité de courant débité. Pour cela, à partir du moment où la tension ou l'état de charge de la cellule est descendu en dessous d'un seuil haut prédéterminé, à chaque instant k, le calculateur 44 calcule la quantité $QC_k$ de courant débité à l'aide de la relation suivante : $QC_k = QC_{k-1} + i_k T_e$. Dès que $QC_k$ dépasse un seuil haut $SH_Q$, alors la phase 166 ou 246 est exécutée. A l'inverse, tant que la quantité $QC_k$ reste supérieure au seuil $SH_Q$, l'exécution des phases 166 ou 246 est inhibée. En variante, la quantité $QC_k$ peut aussi être calculée sur une fenêtre glissante contenant les N derniers instants k, où N est une constante prédéterminée.

Dans un autre mode de réalisation, le déclenchement des estimations de la capacité et/ou de la résistance interne en réponse au franchissement d'un seuil est omis. Par exemple, ces estimations sont déclenchées à intervalle régulier. Cette intervalle régulier est égal à $T_e$ si la puissance de calcul disponible est suffisante pour estimer cette capacité et cette résistance interne à chaque instant k.

De nombreux autres modes de réalisation du procédé de la figure 12 sont possibles. Par exemple, l'opération 205 peut être omise. Dans ce cas, aucune cellule jumelle n'est identifiée et l'étape 212 est aussi omise.

L'opération 202 peut être réalisée différemment. Par exemple, un seul des seuils haut et bas est utilisé. L'opération 202 peut aussi être omise.

Le nombre de niveaux de priorité peut être quelconque et supérieur à au moins deux ou trois. D'autres méthodes pour affecter un niveau de priorité aux cellules sont possibles. Par exemple, le niveau de priorité d'une cellule peut être calculé à l'aide d'une formule qui relie son niveau de priorité à son écart de tension et de sa tension. Dans ce dernier cas, les opérations de comparaison sont omises.

La méthode décrite pour associer des instants de rafraîchissement aux cellules en fonction de leurs niveaux de priorité n'est qu'un exemple. Tout autre procédé connu d'ordonnancement de tâches en fonction du niveau de priorité de ces tâches peut être adapté au cas décrit ici de l'ordonnancement des instants de rafraîchissement des estimations des états de charge des cellules.

La planification des instants de rafraîchissement de l'estimation de l'état de charge de chacune des cellules décrite en référence à la figure 12 peut être omise. Par exemple, cela sera le cas si la puissance de calcul nécessaire pour l'estimation de l'état de charge de chacune des cellules à chaque instant k est disponible.

En variante, le calculateur 44 comprend plusieurs sous-calculateurs programmables capables d'exécuter chacun et en parallèle, le procédé d'estimation de la figure 10 ou 17 pour des cellules respectives.

L'état de santé d'une cellule peut aussi être calculé à l'aide de la relation suivante : $SOH_K = RO_K/RO^{ini}$.

La batterie 10 peut être remplacée par tout type de batterie, comme par exemple, une batterie au plomb, une super-capacité ou une pile à combustible. Dans ce cas, le modèle d'état et/ou le modèle d'observation de l'estimateur 60 peuvent éventuellement être adaptés pour tenir compte de la technologie de la batterie.

Ce qui a été décrit précédemment s'applique aussi au véhicule hybride, c'est-à-dire au véhicule dont l'entraînement des roues motrices est à la fois ou, en alternance, assuré par un moteur électrique et un moteur thermique à combustion interne. Le véhicule 2 peut aussi être un camion, une moto ou un tricycle et de façon générale, tout véhicule capable de se déplacer en entraînant des roues motrices à l'aide d'un moteur électrique alimenté par une batterie. Par exemple, il peut s'agir d'un monte-charge.

La batterie 10 peut être rechargée par l'intermédiaire d'une prise électrique qui permet de la raccorder électriquement à un réseau de distribution d'électricité. La batterie 10 peut aussi être rechargée par un moteur thermique à combustion interne.

## Revendications

1. Procédé d'estimation de l'état de charge d'une cellule d'une batterie, ce procédé comportant la réitération des étapes suivantes à chaque instant k successif :

   a) l'acquisition (110) d'une valeur mesurée $y_k$ d'une tension entre des bornes de la cellule et d'une intensité mesurée $i_k$ d'un courant de charge et de décharge de cette cellule,
   b) le calcul (116) d'une prédiction de l'état de charge $SOC_k$, à l'instant k, de la cellule à l'aide d'un modèle d'état reliant la prédiction $SOC_k$ à un produit $F_k*SOC_{k-1}$ et à la valeur $y_{k-1}$ ou à l'intensité $i_{k-1}$ mesurée à l'instant k-1, où $SOC_{k-1}$ est l'état de charge de cette cellule à l'instant k-1 et $F_k$ est une matrice de transition d'état, cette prédiction de l'état de charge $SOC_k$ étant entachée d'un bruit d'état dont la covariance est donnée par une matrice $Q_k$ de covariance du bruit d'état,
   c) la prédiction (117) de la covariance de l'erreur commise sur la prédiction de l'état de charge $SOC_k$ en fonction, notamment, de la matrice $Q_{k-1}$ de covariance du bruit d'état à l'instant k-1 et d'une matrice $R_{k-1}$ de covariance du bruit de mesure à l'instant k-1,
   d) le calcul (124) d'une prédiction $\hat{y}_k$ de la valeur mesurée $y_k$ à l'instant k à l'aide d'un modèle d'observation qui relie la valeur mesurée $y_k$ à un produit $H_k*SOC_k$, où $H_k$ est une matrice d'observabilité, cette prédiction $\hat{y}_k$ étant entachée d'un bruit de mesure dont la covariance est donnée par la matrice $R_k$ de covariance du bruit de mesure, et

e) la correction (126) de la prédiction de l'état de charge SOCk en fonction de l'écart entre la valeur mesurée $y_k$ et sa prédiction $\hat{y}_k$,

**caractérisé en ce que** ce procédé comporte le réglage (102, 120) des valeurs des matrices $Q_k$ et $R_k$ à l'aide des relations suivantes : $Q_k = [N_0 G_{0,k}(N_0)]^{-1}$ et $R_k = I$, où

- $N_0$ est un entier strictement supérieur à un dont la valeur est prédéterminée,
- $G_{0,k}(N_0)$ est donné par la relation suivante :

$$G_{o,k}(N_o) = \sum_{i=0}^{N_0-1} \left(F_k^{\mathsf{T}}\right)^i H_k^{\mathsf{T}} H_k \left(F_k\right)^i$$

- I est la matrice identité.

2. Procédé selon la revendication 1, dans lequel le réglage (120) des valeurs des matrices $Q_k$ et $R_k$ est réitéré à chaque fois que l'une des matrices $F_k$ et $H_k$ est modifiée.

3. Procédé selon l'une quelconque des revendications précédentes, dans lequel le procédé comporte la construction (118) de la matrice $H_k$ en linéarisant une fonction d'observabilité non linéaire qui relie la valeur mesurée $y_k$ à la prédiction $SOC_k$ de l'état de charge à l'instant k de la cellule.

4. Procédé selon la revendication 3, dans lequel la fonction non linéaire d'observabilité est la fonction suivante : $y_k = OCV(SOC_k) + V_{D,k} + RO_{k2}*i_k$, où :

- $OCV(SOC_k)$ est une fonction connue non linéaire qui retourne la tension à vide de la cellule en fonction de son état de charge, la tension à vide de la cellule étant la tension entre les bornes de cette cellule lorsque ces bornes sont isolées électriquement de toute charge électrique depuis deux heures,
- $V_{D,k}$ est une tension aux bornes d'un circuit RC parallèle comportant une résistance $R_D$ et un condensateur CD, où la résistance $R_D$ et la capacité du condensateur $C_D$ sont des paramètres de la cellule, et
- $RO_{k2}$ est la résistance interne de la cellule.

5. Procédé selon l'une quelconque des revendications précédentes, dans lequel le modèle d'état utilisé lors de l'étape b) pour calculer la prédiction de l'état de charge $SOC_k$ est le suivant :

$$x_{k+1} = \begin{bmatrix} SOC_{k+1} \\ V_{D,k+1} \end{bmatrix} = \begin{bmatrix} 1 & 0 \\ 0 & 1 - \dfrac{Te}{R_D \cdot C_D} \end{bmatrix} \cdot \begin{bmatrix} SOC_k \\ V_{D,k} \end{bmatrix} + \begin{bmatrix} -\dfrac{Te}{C_{n,k}} \\ \dfrac{Te}{C_D} \end{bmatrix} \cdot i_k + w_k$$

où

- $V_{D,k+1}$ et $V_{D,k}$ sont des tensions aux bornes d'un circuit RC parallèle,
- $R_D$ et $C_D$ sont les valeurs de la résistance et de la capacité du circuit RC parallèle,
- $T_e$ est la période de temps qui sépare deux instants quelconques k et k-1 immédiatement successifs d'exécution de l'étape b),
- $C_{n,k}$ est la capacité de la cellule, la capacité de la cellule étant sa capacité maximale à stocker de l'énergie électrique,
- $w_k$ est un bruit d'état blanc gaussien centré dont la matrice de covariance est la matrice $Q_k$.

6. Support (42) d'enregistrement d'informations, **caractérisé en ce qu'**il comporte des instructions pour l'exécution d'un procédé d'estimation conforme à l'une quelconque des revendications précédentes, lorsque ces instructions sont exécutées par un calculateur électronique.

**7.** Système (40) de gestion d'une batterie équipé d'au moins une cellule, ce système comportant un calculateur électronique (44) programmé pour réitérer des étapes suivantes à chaque instant k successif :

a) l'acquisition d'une valeur mesurée $y_k$ d'une tension entre des bornes de la cellule et d'une intensité mesurée $i_k$ d'un courant de charge et de décharge de cette cellule,
b) le calcul d'une prédiction de l'état de charge $SOC_k$, à l'instant k, de la cellule à l'aide d'un modèle d'état reliant la prédiction $SOC_k$ à un produit $F_k*SOC_{k-1}$ et à la valeur $y_{k-1}$ ou à l'intensité $i_{k-1}$ mesurée à l'instant k-1, où $SOC_{k-1}$ est l'état de charge de cette cellule à l'instant k-1 et $F_k$ est une matrice de transition d'état, cette prédiction de l'état de charge $SOC_k$ étant entachée d'un bruit d'état dont la covariance est donnée par une matrice $Q_k$ de covariance du bruit d'état,
c) la prédiction de la covariance de l'erreur commise sur la prédiction de l'état de charge $SOC_k$ en fonction, notamment, de la matrice $Q_{k-1}$ de covariance du bruit d'état à l'instant k-1 et d'une matrice $R_{k-1}$ de covariance du bruit de mesure à l'instant k-1,
d) le calcul d'une prédiction $\hat{y}_k$ de la valeur mesurée $y_k$ à l'instant k à l'aide d'un modèle d'observation qui relie la valeur mesurée $y_k$ à un produit $H_k*SOC_k$, où $H_k$ est une matrice d'observabilité, cette prédiction $\hat{y}_k$ étant entachée d'un bruit de mesure dont la covariance est donnée par la matrice $R_k$ de covariance du bruit de mesure, et
e) la correction de la prédiction de l'état de charge $SOC_k$ en fonction de l'écart entre la valeur mesurée $y_k$ et sa prédiction $\hat{y}_k$,
**caractérisé en ce que** le calculateur (44) est également programmé pour régler des valeurs des matrices $Q_k$ et $R_k$ à l'aide des relations suivantes : $Q_k = [N_0 G_{0,k}(N_0)]^{-1}$ et $R_k = I$, où

- $N_0$ est un entier strictement supérieur à un dont la valeur est prédéterminée,
- $G_{0,k}(N_0)$ est donné par la relation suivante :

$$G_{0,k}(N_0) = \sum_{i=0}^{N_0-1} (F_k^T)^i H_k^T H_k (F_k)^i$$

- I est la matrice identité.

**8.** Véhicule automobile comportant :

- au moins une roue motrice (6),
- un moteur électrique (4) apte à entraîner en rotation cette roue motrice pour déplacer le véhicule automobile,
- une batterie (10) comportant au moins une cellule (18-21) apte à stocker de l'énergie électrique et, en alternance, à restituer de l'énergie électrique pour alimenter le moteur électrique, cette cellule comportant deux bornes (30, 32) par l'intermédiaire desquelles elle est électriquement raccordée au moteur électrique,
- un voltmètre (34) raccordé électriquement entre les bornes de la cellule pour mesurer la tension entre ces bornes,
- un ampèremètre (36) raccordé en série avec la cellule électrique pour mesurer l'intensité du courant de charge ou de décharge de cette cellule, et
- un système (40) de gestion de la batterie raccordé au voltmètre et à l'ampèremètre, ce système de gestion comportant un calculateur électronique (44) programmable apte à estimer l'état de charge de la cellule de la batterie à partir des mesures du voltmètre et de l'ampèremètre,
**caractérisé en ce que** le système (40) de gestion de la batterie est conforme à la revendication 7.

**Patentansprüche**

**1.** Verfahren zur Schätzung des Ladezustands einer Zelle einer Batterie, wobei dieses Verfahren das Wiederholen der folgenden Schritte zu jedem aufeinanderfolgenden Zeitpunkt k umfasst:

a) die Erfassung (110) eines Messwerts $y_k$ einer Spannung zwischen Klemmen der Zelle und einer gemessenen

Stromstärke $i_k$ eines Lade- und Entladestroms dieser Zelle,

b) die Berechnung (116) einer Vorhersage des Ladezustands $SOCk$ der Zelle zum Zeitpunkt k mithilfe eines Zustandsmodells, das die Vorhersage $SOCk$ mit einem Produkt $F_k*SOC_{k-1}$ und mit dem Wert $y_{k-1}$ oder mit der zum Zeitpunkt k-1 gemessenen Stromstärke $i_{k-1}$ verknüpft, worin $SOC_{k-1}$ der Ladezustand dieser Zelle zum Zeitpunkt k-1 ist und $F_k$ eine Zustandsübergangsmatrix ist, wobei diese Vorhersage des Ladezustands $SOC_k$ mit einem Zustandsrauschen behaftet ist, dessen Kovarianz durch eine Kovarianzmatrix $Q_k$ des Zustandsrauschens gegeben ist,

c) die Vorhersage (117) der Kovarianz des bei der Vorhersage des Ladezustands $SOCk$ begangenen Fehlers in Abhängigkeit insbesondere von der Kovarianzmatrix $Q_{k-1}$ des Zustandsrauschens zum Zeitpunkt k-1 und von einer Kovarianzmatrix $R_{k-1}$ des Messrauschens zum Zeitpunkt k-1,

d) die Berechnung (124) einer Vorhersage $\hat{y}_k$ des Messwerts $y_k$ zum Zeitpunkt k mithilfe eines Beobachtungsmodells, das den Messwert $y_k$ mit einem Produkt $H_k*SOC_k$ verknüpft, worin $H_k$ eine Beobachtbarkeitsmatrix ist, wobei diese Vorhersage $\hat{y}_k$ mit einem Messrauschen behaftet ist, dessen Kovarianz durch die Kovarianzmatrix $R_k$ des Messrauschens gegeben ist, und

e) die Korrektur (126) der Vorhersage des Ladezustands $SOC_k$ in Abhängigkeit von der Abweichung zwischen dem Messwert $y_k$ und seiner Vorhersage $\hat{y}_k$,

wobei dieses Verfahren das Einstellen (102, 120) der Werte der Matrizen $Q_k$ und $R_k$ mithilfe der folgenden Gleichungen umfasst: $Q_k = [N_oG_{0,k}(N_0)]^{-1}$ und $R_k = I$, worin

- $N_0$ eine ganze Zahl größer eins ist, deren Wert vorgegeben ist,
- $G_{0,k}(N_0)$ durch die folgende Gleichung gegeben ist:

$$G_{0,k}\left(N_0\right) = \sum_{i=0}^{N_0-1} \left(F_k^T\right)^i H_k^T H_k \left(F_k\right)^i$$

- I die Identitätsmatrix ist.

2. Verfahren nach Anspruch 1, bei dem das Einstellen (120) der Werte der Matrizen $Q_k$ und $R_k$ immer dann wiederholt wird, wenn eine der Matrizen $F_k$ und $H_k$ geändert wird.

3. Verfahren nach einem der vorhergehenden Ansprüche, bei dem das Verfahren die Konstruktion (118) der Matrix $H_k$ umfasst, indem eine nichtlineare Beobachtbarkeitsfunktion, die den Messwert $y_k$ mit der Vorhersage $SOC_k$ des Ladezustands zum Zeitpunkt k der Zelle verknüpft, linearisiert wird.

4. Verfahren nach Anspruch 3, bei dem die nichtlineare Beobachtbarkeitsfunktion die folgende Funktion ist: $y_k = OCV(SOC_k) + V_{D,k} + RO_{k2}*i_k$, worin:

- $OCV(SOC_k)$ eine bekannte nichtlineare Funktion ist, welche die Leerlaufspannung der Zelle in Abhängigkeit von ihrem Ladezustand ausgibt, wobei die Leerlaufspannung der Zelle die Spannung zwischen den Klemmen dieser Zelle ist, wenn diese Klemmen seit zwei Stunden von jeder elektrischen Last elektrisch isoliert sind,
- $V_{D,k}$ eine Spannung an den Klemmen einer RC-Parallelschaltung ist, die einen Widerstand $R_D$ und einen Kondensator $C_D$ umfasst, wobei der Widerstand $R_D$ und die Kapazität des Kondensators $C_D$ Parameter der Zelle sind, und
- $RO_{k2}$ der Innenwiderstand der Zelle ist.

5. Verfahren nach einem der vorhergehenden Ansprüche, bei dem im Schritt b) zum Berechnen der Vorhersage des Ladezustands $SOCk$ das folgende Zustandsmodell verwendet wird:

$$x_{k+1} = \begin{bmatrix} SOC_{k+1} \\ V_{D,k+1} \end{bmatrix} = \begin{bmatrix} 1 & 0 \\ 0 & 1 - \dfrac{T_e}{R_D \cdot C_D} \end{bmatrix} \cdot \begin{bmatrix} SOC_k \\ V_{D,k} \end{bmatrix} + \begin{bmatrix} \dfrac{-Te}{C_{n,k}} \\ \dfrac{Te}{C_D} \end{bmatrix} \cdot i_k + w_k$$

worin

- $V_{D,k+1}$ und $V_{D,k}$ Spannungen an den Klemmen einer RC-Parallelschaltung sind,
- $R_D$ und $C_D$ Werte des Widerstands und der Kapazität der RC-Parallelschaltung sind,
- $T_e$ der Zeitraum ist, der zwei beliebige unmittelbar aufeinanderfolgende Ausführungszeitpunkte k und k-1 des Schritts b) trennt,
- $C_{n,k}$ die Kapazität der Zelle ist, wobei die Kapazität der Zelle ihre maximale Kapazität ist, elektrische Energie zu speichern,
- $w_k$ zentriertes Gaußsches weißes Zustandsrauschen ist, dessen Kovarianzmatrix die Matrix $Q_k$ ist.

6. Datenspeichermedium (42), **dadurch gekennzeichnet, dass** es Anweisungen umfasst zur Ausführung eines Verfahrens zur Schätzung nach einem der vorhergehenden Ansprüche, wenn diese Anweisungen von einem elektronischen Rechner ausgeführt werden.

7. Managementsystem (40) für eine Batterie, die mit mindestens einer Zelle ausgestattet ist, wobei dieses System einen elektronischen Rechner (44) umfasst, der dazu programmiert ist, die folgenden Schritte zu jedem aufeinanderfolgenden Zeitpunkt k zu wiederholen:

a) die Erfassung eines Messwerts $y_k$ einer Spannung zwischen Klemmen der Zelle und einer gemessenen Stromstärke $i_k$ eines Lade- und Entladestroms dieser Zelle,
b) die Berechnung einer Vorhersage des Ladezustands SOCk der Zelle zum Zeitpunkt k mithilfe eines Zustandsmodells, das die Vorhersage SOCk mit einem Produkt $F_k$*$SOC_{k-1}$ und mit dem Wert $y_{k-1}$ oder mit der zum Zeitpunkt k-1 gemessenen Stromstärke $i_{k-1}$ verknüpft, worin $SOC_{k-1}$ der Ladezustand dieser Zelle zum Zeitpunkt k-1 ist und $F_k$ eine Zustandsübergangsmatrix ist, wobei diese Vorhersage des Ladezustands $SOC_k$ mit einem Zustandsrauschen behaftet ist, dessen Kovarianz durch eine Kovarianzmatrix $Q_k$ des Zustandsrauschens gegeben ist,
c) die Vorhersage der Kovarianz des bei der Vorhersage des Ladezustands $SOC_k$ begangenen Fehlers in Abhängigkeit insbesondere von der Kovarianzmatrix $Q_{k-1}$ des Zustandsrauschens zum Zeitpunkt k-1 und von einer Kovarianzmatrix $R_{k-1}$ des Messrauschens zum Zeitpunkt k-1,
d) die Berechnung einer Vorhersage $\hat{y}_k$ des Messwerts $y_k$ zum Zeitpunkt k mithilfe eines Beobachtungsmodells, das den Messwert $y_k$ mit einem Produkt $H_k$*$SOC_k$ verknüpft, worin $H_k$ eine Beobachtbarkeitsmatrix ist, wobei diese Vorhersage $\hat{y}_k$ mit einem Messrauschen behaftet ist, dessen Kovarianz durch die Kovarianzmatrix $R_k$ des Messrauschens gegeben ist, und
e) die Korrektur der Vorhersage des Ladezustands SOCk in Abhängigkeit von der Abweichung zwischen dem Messwert $y_k$ und seiner Vorhersage $\hat{y}_k$,
**dadurch gekennzeichnet, dass** der Rechner (44) auch dazu programmiert ist, Werte der Matrizen $Q_k$ und $R_k$ mithilfe der folgenden Gleichungen einzustellen: $Q_k = [N_0 G_{0,k}(N_0)]^{-1}$ und $R_k = I$, worin

- $N_0$ eine ganze Zahl größer eins ist, deren Wert vorgegeben ist,
- $G_{0,k}(N_0)$ durch die folgende Gleichung gegeben ist:

$$G_{0,k}(N_0) = \sum_{i=0}^{N_0-1} \left( F_k^T \right)^i H_k^T H_k \left( F_k \right)^i$$

- I die Identitätsmatrix ist.

8. Kraftfahrzeug, umfassend:

- mindestens ein Antriebsrad (6),
- einen Elektromotor (4), der in der Lage ist, dieses Antriebsrad drehanzutreiben, um das Kraftfahrzeug zu bewegen,
- eine Batterie (10), die mindestens eine Zelle (18-21) umfasst, die in der Lage ist, elektrische Energie zu speichern und alternierend elektrische Energie abzugeben, um den Elektromotor zu speisen, wobei diese Zelle zwei Klemmen (30, 32) umfasst, über die sie elektrisch an den Elektromotor angeschlossen ist,
- ein Voltmeter (34), das elektrisch zwischen den Klemmen der Zelle angeschlossen ist, um die Spannung zwischen diesen Klemmen zu messen,
- ein Amperemeter (36), das in Reihe mit der elektrischen Zelle angeschlossen ist, um die Stärke des Lade- oder Entladestroms dieser Zelle zu messen, und
- ein Batteriemanagementsystem (40), das an das Voltmeter und an das Amperemeter angeschlossen ist, wobei dieses Managementsystem einen programmierbaren elektronischen Rechner (44) umfasst, der in der Lage ist, den Ladezustand der Zelle der Batterie ausgehend von den Messungen des Voltmeters und des Amperemeters zu schätzen,

**dadurch gekennzeichnet, dass** das Batteriemanagementsystem (40) ein Managementsystem nach Anspruch 7 ist.

**Claims**

1. Method for estimating the state of charge of a cell of a battery, this method including reiterating the following steps at each successive instant k:

   a) acquiring (110) a measured value $y_k$ of a voltage across the terminals of the cell and a measured intensity $i_k$ of a charging and discharging current of this cell;

   b) calculating (116), at the instant k, a prediction of the state of charge $SOC_k$ of the cell using a state model relating the prediction $SOC_k$ to a product $F_k*SOC_{k-1}$ and to the value $y_{k-1}$ or to the intensity $i_{k-1}$ measured at the instant k-1, where $SOC_{k-1}$ is the state of charge of this cell at the instant k-1 and $F_k$ is a state transition matrix, this prediction of the state of charge $SOC_k$ being corrupted with a state noise the covariance of which is given by a covariance matrix $Q_k$ of the state noise;

   c) predicting (117) the covariance of the error in the prediction of the state of charge $SOC_k$ from, in particular, the covariance matrix $Q_{k-1}$ of the state noise at the instant k-1 and a covariance matrix $R_{k-1}$ of the measurement noise at the instant k-1;

   d) calculating (124) a prediction $\hat{y}_k$ of what the measured value $y_k$ will be at the instant k using an observation model that relates the measured value $y_k$ to a product $H_k*SOC_k$, where $H_k$ is an observability matrix, this prediction $\hat{y}_k$ being corrupted with measurement noise the covariance of which is given by the covariance matrix $R_k$ of the measurement noise; and

   e) correcting (126) the prediction of the state of charge SOCk depending on the difference between the measured value $y_k$ and its prediction $\hat{y}_k$;

   **characterized in that** this method includes setting (102, 120) values of the matrices $Q_k$ and Rk using the following relationships: $Q_k = [N_0 G_{0,k}(N_0)]^{-1}$ and $R_k = I$, where

   - $N_0$ is an integer strictly higher than one the value of which is preset,
   - $G_{0,k}(N_0)$ is given by the following relationship:

$$G_{o,k}(N_o) = \sum_{i=0}^{N_o-1} \left(F_k^{\mathrm{T}}\right)^i H_k^{\mathrm{T}} H_k (F_k)^i$$

   - and I is the identity matrix.

2. Method according to Claim 1, wherein the setting (120) of the values of the matrices $Q_k$ and $R_k$ is reiterated each time one of the matrices $F_k$ and $H_k$ is modified.

3. Method according to any one of the preceding claims, wherein the method includes constructing (118) the matrix $H_k$ by linearizing a non-linear observability function that relates the measured value $y_k$ to the prediction $SOC_k$ of the state of charge of the cell at the instant k.

4. Method according to Claim 3, wherein the non-linear observability function is the following function: $y_k = OCV(SOC_k) + V_{D,k} + RO_{k2}*i_k$, where:

   - $OCV(SOC_k)$ is a known non-linear function that expresses the open-circuit voltage of the cell as a function of its state of charge, the open-circuit voltage of the cell being the voltage across the terminals of this cell when these terminals have been electrically isolated from any electrical load for two hours,
   - $V_{D,k}$ is a voltage across the terminals of a parallel RC circuit including a resistor $R_D$ and a capacitor $C_D$, where the resistance of the resistor $R_D$ and the capacitance of the capacitor $C_D$ are parameters of the cell, and
   - $RO_{k2}$ is the internal resistance of the cell.

5. Method according to any one of the preceding claims, wherein the state model used in step b) to calculate the prediction of the state of charge $SOC_k$ is the following:

$$x_{k+1} = \begin{bmatrix} SOC_{k+1} \\ V_{D,k+1} \end{bmatrix} = \begin{bmatrix} 1 & 0 \\ 0 & 1 - \dfrac{Te}{R_D \cdot C_D} \end{bmatrix} \cdot \begin{bmatrix} SOC_k \\ V_{D,k} \end{bmatrix} + \begin{bmatrix} -\dfrac{Te}{C_{n,k}} \\ \dfrac{Te}{C_D} \end{bmatrix} \cdot i_k + w_k$$

where

- $V_{D,k+1}$ and $V_{D,k}$ are voltages across the terminals of a parallel RC circuit,
- $R_D$ and $C_D$ are the resistance and capacitance of the parallel RC circuit,
- $T_e$ is the time period that separates any two immediately successive instants k and k-1 of execution of step b),
- $C_{n,k}$ is the capacity of the cell, the capacity of the cell being its maximum capacity to store electrical energy,
- $w_k$ is a centered Gaussian white state noise the covariance matrix of which is the matrix $Q_k$.

6. Data storage medium (42), **characterized in that** it includes instructions for executing an estimating method according to any one of the preceding claims, when these instructions are executed by an electronic processor.

7. System (40) for managing a battery equipped with at least one cell, this system including an electronic processor (44) programmed to reiterate the following steps at each successive instant k:

a) acquiring a measured value $y_k$ of a voltage across the terminals of the cell and a measured intensity $i_k$ of a charging and discharging current of this cell;
b) calculating, at the instant k, a prediction of the state of charge $SOC_k$ of the cell using a state model relating the prediction $SOC_k$ to a product $F_k*SOC_{k-1}$ and to the value $y_{k-1}$ or to the intensity $i_{k-1}$ measured at the instant k-1, where $SOC_{k-1}$ is the state of charge of this cell at the instant k-1 and $F_k$ is a state transition matrix, this prediction of the state of charge $SOC_k$ being corrupted with a state noise the covariance of which is given by a covariance matrix $Q_k$ of the state noise;
c) predicting the covariance of the error in the prediction of the state of charge SOCk from, in particular, the covariance matrix $Q_{k-1}$ of the state noise at the instant k-1 and a covariance matrix $R_{k-1}$ of the measurement noise at the instant k-1;
d) calculating a prediction $\hat{y}_k$ of what the measured value $y_k$ will be at the instant k using an observation model that relates the measured value $y_k$ to a product $H_k*SOC_k$, where $H_k$ is an observability matrix, this prediction $\hat{y}_k$ being corrupted with measurement noise the covariance of which is given by the covariance matrix $R_k$ of the measurement noise; and
e) correcting the prediction of the state of charge $SOC_k$ depending on the difference between the measured value $y_k$ and its prediction $\hat{y}_k$;
**characterized in that** the processor (44) is also programmed to set the values of the matrices $Q_k$ and $R_k$ using the following relationships: $Q_k = [N_0 G_{0,k}(N_0)]^{-1}$ and $R_k = I$, where

- $N_0$ is an integer strictly higher than one the value of which is preset,
- $G_{0,k}(N_0)$ is given by the following relationship:

$$G_{o,k}(N_o) = \sum_{i=0}^{N_o-1} \left(F_k^{\mathrm{T}}\right)^i H_k^{\mathrm{T}} H_k (F_k)^i$$

- and I is the identity matrix.

8. Motor vehicle including:

- at least one drive wheel (6);
- an electric motor (4) able to drive this drive wheel to rotate in order to move the motor vehicle;

- a battery (10) including at least one cell (18-21) able to store electrical energy and, in alternation, release the electrical energy to power the electrical motor, this cell including two terminals (30, 32) by way of which the cell is electrically connected to the electrical motor;
- a voltmeter (34) electrically connected between the terminals of the cell in order to measure the voltage across these terminals;
- an ammeter (36) connected in series with the electrical cell, in order to measure the intensity of the current charging or discharging the cell; and
- a system (40) for managing the battery, this system being connected to the voltmeter and to the ammeter and including a programmable electronic processor (44) that is able to estimate the state of charge of the cell of the battery from the measurements of the voltmeter and ammeter;

**characterized in that** the system (40) for managing the battery is according to Claim 7.

Fig. 1

Fig. 2

Fig. 3

$$62 \rightarrow x_{k+1} = \begin{bmatrix} SOC_{k+1} \\ V_{D,k+1} \end{bmatrix} = \begin{bmatrix} 1 & 0 \\ 0 & 1 - \dfrac{Te}{R_D \cdot C_D} \end{bmatrix} \cdot \begin{bmatrix} SOC_k \\ V_{D,k} \end{bmatrix} + \begin{bmatrix} -\dfrac{Te}{C_{n,k3}} \\ \dfrac{Te}{C_D} \end{bmatrix} i_k + w_k$$

$$\text{Fig. 4}$$

$$64 \rightarrow y_k = OCV(SOC_k) - V_{D,k} - RO_{k2} i_k + v_k$$

$$\text{Fig. 5}$$

$$70 \rightarrow RO_{k2+1} = RO_{k2} + w_{2,k2}$$

$$\text{Fig. 6}$$

$$72 \rightarrow u_{k2} = \sum_{m=k-N}^{k} [OCV(SOC_m) - V_{D,m} - RO_{k2} \cdot i_m] + v_{2,k2}$$

$$\text{Fig. 7}$$

$$74 \rightarrow C_{n,k3+1} = C_{n,k3} + v_{3,k3}$$

$$\text{Fig.8}$$

$$76 \rightarrow z_{k3} = \frac{(SOC_k - SOC_{k-N})}{N\,Te} \cdot 3600 \cdot C_{n,k3} + v_{3,k3}$$

$$\text{Fig. 9}$$

Fig. 10

Fig. 11

Fig. 12

Fig. 13

Fig. 14

$$232 \quad x_{k+1} = \begin{bmatrix} RO_{k4+1} \\ C_{n,k4+1} \end{bmatrix} = \begin{bmatrix} 1 & 0 \\ 0 & 1 \end{bmatrix} \cdot \begin{bmatrix} RO_{k4} \\ C_{n,k4} \end{bmatrix} + w_{d,k4}$$

Fig. 15

$$234 \quad \begin{bmatrix} u_{k4} \\ z_{k4} \end{bmatrix} = \begin{bmatrix} \sum_{m=k-N}^{k} [OCV(SOC_m) - V_{D,m} - RO_{k4} \cdot i_m] \\ \dfrac{(SOC_k - SOC_{k-N})}{N\,Te} \cdot 3600 \cdot C_{n,k4} \end{bmatrix} + v_{d,k4}$$

Fig. 16

Fig. 17

$$250 \quad x_{k+1} = \begin{bmatrix} RO_{k4+1} \\ C_{n,k4+1} \end{bmatrix} = \begin{bmatrix} \left(\alpha + \dfrac{\beta N_k^C}{N_{EOL}^C}\right) & 0 \\ 0 & \left(1 + \dfrac{\gamma \cdot N_k^C}{N_{EOL}^C}\right) \end{bmatrix} \cdot \begin{bmatrix} RO_k \\ C_{n,k} \end{bmatrix} + w_{d,k}^a$$

Fig. 18

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050046388 A1
- US 6441586 B1
- WO 2006057468 A

**Littérature non-brevet citée dans la description**

- **L. PLETT et al.** Extended Kalman filtering for battery management systems of LiPB-based HEV battery packs. *journal of Power Sources,* 2004, 252-292
- **MEHRA, R.K.** On the identification of variances and adaptative Kalman Filtering. *Automatic Control, IEEE Transaction on,* Avril 1970, vol. 15 (2), 175-184
- Estimation With Applications to Tracking and Navigation. **Y. BAR-SHALOM et al.** Theory Algorithms and Software. Wiley Inter-science, 2001